# EUROPEAN PATENT APPLICATION

(11) **EP 4 401 122 A1**
(43) Date of publication of application: **17.07.2024**
(21) Application number: 23192351.7
(22) Date of filing: 21.08.2023
(51) Int. Cl.: H01L 21/8234, H01L 27/088, H01L 29/06, H01L 29/775

(54) **SEMICONDUCTOR DEVICE AND A METHOD OF MANUFACTURING THE SAME**

(30) Priority: 10.01.2023 KR 20230003698
(71) Applicant: Samsung Electronics Co., Ltd., Suwon-si, Gyeonggi-do 16677 (KR)
(72) Inventor: JEONG, Soojin, 16677 Suwon-si, Gyeonggi-do (KR); KANG, Myung Gil, 16677 Suwon-si, Gyeonggi-do (KR); PARK, Beomjin, 16677 Suwon-si, Gyeonggi-do (KR); KIM, Dongwon, 16677 Suwon-si, Gyeonggi-do (KR); KIM, Younggwon, 16677 Suwon-si, Gyeonggi-do (KR); YOO, Hyumin, 16677 Suwon-si, Gyeonggi-do (KR)
(74) Representative: Kuhnen & Wacker Patent- und Rechtsanwaltsbüro PartG mbB

(57) **Abstract**

A semiconductor device includes a substrate including first and second active regions (NR, PR), a first active pattern (AP1) on the first active region, a second active pattern (AP2) on the second active region, a device isolation layer (ST) filling a trench (TR) between the first active pattern and the second active pattern, the device isolation layer having a concave top surface, a first gate electrode (GE) in the first active region, a second gate electrode (GE) in the second active region, a gate cutting pattern (CT) disposed between the first gate electrode and the second gate electrode and separating the first gate electrode and the second gate electrode, and an insulating pattern (IP) between the gate cutting pattern and the concave top surface of the device isolation layer.

## Description

### CROSS-REFERENCE TO RELATED APPLICATIONS

This application claims priority under 35 U.S.C. §119 to Korean Patent Application No. 10-2023-0003698, filed on January 10, 2023, in the Korean Intellectual Property Office, the entire contents of which are hereby incorporated by reference.

### TECHNICAL FIELD

The present disclosure relates to a semiconductor device and a method of manufacturing the same, and more particularly, to a semiconductor device including a field effect transistor and a method of manufacturing the same.

### DISCUSSION OF RELATED ART

Semiconductor devices may include integrated circuits (ICs) including metal-oxide-semiconductor field effect transistors (MOSFETs). The MOSFET is a widely used transistor, and is building block of many ICs. As sizes and design rules of semiconductor devices have been reduced to increase a degree of integration, the sizes of the MOSFETs have also been scaled down. Operating characteristics of semiconductor devices may be impacted by the reduction in the sizes of MOSFETs, which may be suspectable to short channel effects, tunneling effects, etc., with reduced size. Accordingly, various methods for manufacturing semiconductor devices having improved performance while overcoming the challenges of high integration devices have been studied.

### SUMMARY

Embodiments of the inventive concepts may provide a semiconductor device with improved reliability and electrical characteristics.

Embodiments of the inventive concepts may also provide a method of manufacturing a semiconductor device with improved reliability and electrical characteristics.

In an aspect, a semiconductor device may include a substrate including a first active region and a second active region; a first active pattern on the first active region; a second active pattern on the second active region; a device isolation layer filling a trench between the first active pattern and the second active pattern, the device isolation layer having a concave top surface; a first gate electrode in the first active region; a second gate electrode in the second active region; a gate cutting pattern disposed between the first gate electrode and the second gate electrode and separating the first gate electrode and the second gate electrode; and an insulating pattern between the gate cutting pattern and the concave top surface of the device isolation layer.

In an aspect, a semiconductor device may include a substrate; a device isolation layer on the substrate; a gate cutting pattern on the device isolation layer; a gate spacer on a sidewall of the gate cutting pattern; an interlayer insulating layer on the device isolation layer and the gate spacer; and an insulating pattern between the device isolation layer and the interlayer insulating layer and between the gate spacer and the interlayer insulating layer. The insulating pattern may include a first portion disposed between the interlayer insulating layer and the gate spacer; and a second portion disposed between the interlayer insulating layer and the device isolation layer.

In an aspect, a semiconductor device may include a substrate including a logic cell, the logic cell including a PMOSFET region and an NMOSFET region which are spaced apart from each other in a first direction, the logic cell having a first boundary, a second boundary, a third boundary, and a fourth boundary, the first boundary and the second boundary disposed opposite to each other in a second direction intersecting the first direction, and the third boundary and the fourth boundary disposed opposite to each other in the first direction; a device isolation layer provided on the substrate defining a first active pattern on the PMOSFET region and defining a second active pattern on the NMOSFET region, the first active pattern and the second active pattern extending in the second direction, and the first active pattern and the second active pattern having upper portions protruding above the device isolation layer; a gate electrode extending in the first direction and intersecting the first active pattern and the second active pattern; a first source/drain patterns disposed in the upper portions of the first active pattern at a first side of the gate electrode; a second source/drain pattern disposed in the upper portion of the second active pattern, at a second side of the gate electrode; a pair of gate spacers on sidewalls of the gate electrode, the pair of gate spacers extending in the first direction; a gate capping pattern on the gate electrode; an isolation structure provided on at least one of the first boundary or the second boundary; a gate cutting pattern provided on at least one of the third boundary or the fourth boundary, the gate cutting pattern having a lower portion provided between the pair of gate spacers, and the gate cutting pattern aligned with the gate electrode in the first direction; an interlayer insulating layer on the gate capping pattern and the gate cutting pattern; an active contact penetrating the interlayer insulating layer and electrically connected to at least one of the first source/drain pattern or the second source/drain pattern; a gate contact penetrating the interlayer insulating layer and the gate capping pattern and electrically connected to the gate electrode; a first metal layer on the interlayer insulating layer, the first metal layer comprising a power interconnection line vertically overlapping with the gate cutting pattern, and a first interconnection line electrically connected to the active contact and the gate contact, respectively; a second metal layer on the first metal layer, the second metal layer comprising a second interconnection line electrically connected to the first metal layer; and an insulating pattern disposed between the gate cutting pattern and the device isolation layer and between the gate electrode and the device isolation layer.

### BRIEF DESCRIPTION OF THE DRAWINGS

FIG. 1, FIG. 2, and FIG. 3 are conceptual views illustrating logic cells of a semiconductor device according to some embodiments of the inventive concepts.
FIG. 4 is a plan view illustrating a semiconductor device according to some embodiments of the inventive concepts.
FIG. 5A is a cross-sectional view taken along line A-A' of FIG. 4.
FIG. 5B, is a cross-sectional view taken along line B-B' of FIG. 4.
FIG. 5C is a cross-sectional view taken along line C-C' of FIG. 4.
FIG. 5D is a cross-sectional view taken along line D-D' of FIG. 4.
FIG. 5E is a cross-sectional view taken along line E-E' of FIG. 4
FIG. 6 is an enlarged view of a region 'M' of FIG. 5A.
FIG. 7 is an enlarged view of a region 'N' of FIG. 5C.
FIG. 8A, FIG. 8B, FIG. 8C, FIG. 8D, FIG. 8E, and FIG. 8F are enlarged views corresponding to the region 'M' of FIG. 5A to illustrate semiconductor devices according to some embodiments of the inventive concepts.
FIG. 9A, FIG. 9B, FIG. 10, FIG. 11A, FIG. 11B, FIG. 12A, FIG. 12B, FIG. 13, FIG. 14A, FIG. 14B, FIG. 14C, FIG. 15A, FIG. 15B, FIG. 15C, FIG. 16, and FIG. 17 are cross-sectional views illustrating a method of manufacturing a semiconductor device according to some embodiments of the inventive concepts.

### DETAILED DESCRIPTION

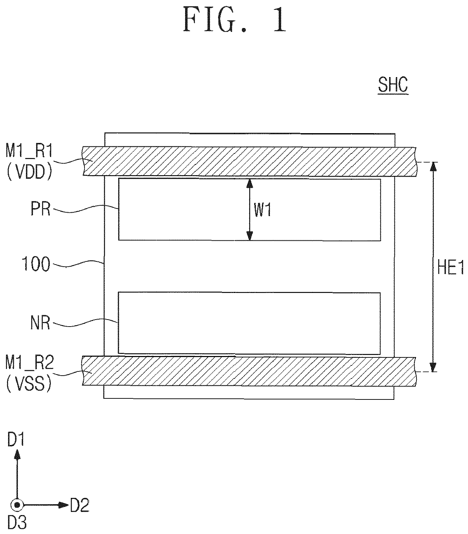

FIG. 1, FIG. 2, and FIG. 3 are conceptual views illustrating logic cells of a semiconductor device according to some embodiments of the inventive concepts.

Referring to FIG. 1, a single height cell SHC may be provided. More particularly, a first power interconnection line M1_R1 and a second power interconnection line M1_R2 may be provided on a substrate 100 and the single height cell SHC may be defined between the first power interconnection line M1_R1 and the second power interconnection line M1_R2. The first power interconnection line M1_R1 may be a path through which a source voltage VSS (e.g., a ground voltage) is provided. The second power interconnection line M1_R2 may be a path through which a drain voltage VDD (e.g., a power voltage) is provided.

The single height cell SHC may be defined between the first power interconnection line M1_R1 and the second power interconnection line M1 R2. The single height cell SHC may include a first active region PR and a second active region NR. The first active region PR may be a PMOSFET region and the second active region NR may be an NMOSFET region. Alternatively, the second active region NR may be a PMOSFET region and the first active region PR may be an NMOSFET region. In other words, the single height cell SHC may have a CMOS structure provided between the first power interconnection line M1_R1 and the second power interconnection line M1_R2. For example, the first active region PR may be the PMOSFET region and the second active region NR may be the NMOSFET region.

Each of the first active region PR and the second active region NR may have a first width W1 in a first direction D 1. A length of the single height cell SHC in the first direction D1 may be defined as a first height HE1. The first height HE1 may be substantially equal to a distance (e.g., a pitch) between the first power interconnection line M1_R1 and the second power interconnection line M1_R2.

The single height cell SHC may form a logic cell. In the present specification, the logic cell may mean a logic element (e.g., an AND element, an OR element, an XOR element, an XNOR element, an inverter, etc.) for performing a specific function. The logic cell may include, for example, transistors and interconnection lines connecting the transistors to each other, which constitute the logic element.

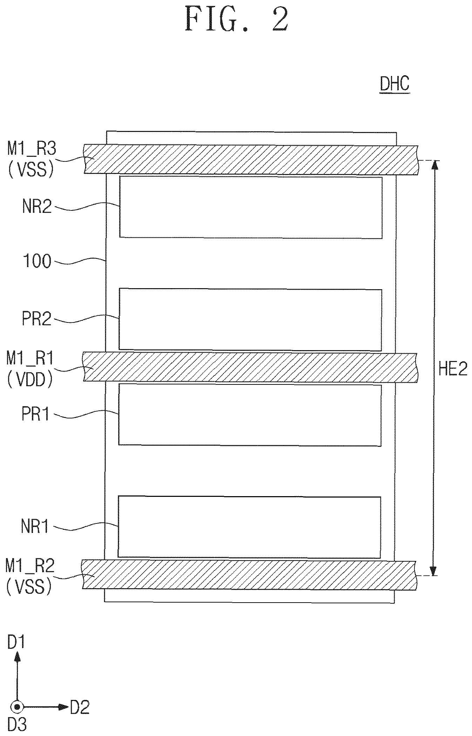

Referring to FIG. 2, a double height cell DHC may be provided. More particularly, a first power interconnection line M1_R1, a second power interconnection line M1_R2 and a third power interconnection line M1_R3 may be provided on a substrate 100. The first power interconnection line M1_R1 may be disposed between the second power interconnection line M1_R2 and the third power interconnection line M1_R3. The second power interconnection line M1_R2 may be a first path through which a source voltage VSS is provided. The third power interconnection line M1_R3 may be a second path through which a source voltage VSS is provided. The second power interconnection line M1_R2 may be a path through which a drain voltage VDD is provided.

The double height cell DHC may be defined between the second power interconnection line M1_R2 and the third power interconnection line M1_R3. The double height cell DHC may include a plurality of active regions. For example, the double height cell DHC may include first active regions PR1 and PR2 and second active regions NR1 and NR2.

One active region of the second active regions NR1 and NR2 may be adjacent to the second power interconnection line M1_R2. Another active region of the second active regions NR1 and NR2 may be adjacent to the third power interconnection line M1_R3. The first active regions PR1 and PR2 may be adjacent to the first power interconnection line M1_R1. The first power interconnection line M1R1 may be disposed between the first active regions PR1 and PR2 when viewed in a plan view. For example, relative to the first power interconnection line M1_R1, a first active region of the second active regions NR1 and NR2 may face a first active region of the first active regions PR1 and PR2, and a second active region of the second active regions NR1 and NR2 may face a second active region of the first active regions PR1 and PR2.

A length of the double height cell DHC in the first direction D1 may be defined as a second height HE2. The second height HE2 may be about twice the first height HE1 of FIG. 1. The first active regions PR1 and PR2 of the double height cell DHC may be combined with each other to operate as a single active region.

In the inventive concepts, the double height cell DHC shown in FIG. 2 may be defined as a multi-height cell. Even though not shown in the drawings, the multi-height cell may include a triple height cell with a cell height is about three times that of the single height cell SHC.

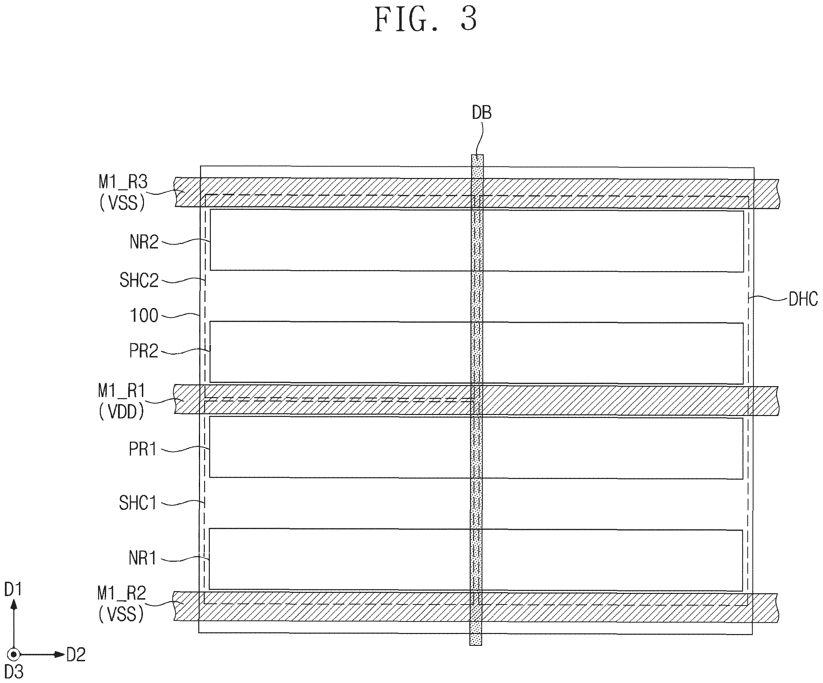

Referring to FIG. 3, a first single height cell SHC1, a second single height cell SHC2, and a double height cell DHC may be disposed on a substrate 100. The first single height cell SHC1, the second single height cell SHC2, and the double height cell DHC may be disposed on a same level of the substrate 100, that is, two-dimensionally disposed on the substrate 100. The first single height cell SHC1 may be disposed between the first power interconnection line M1_R1 and the second power interconnection line M1_R2. The second single height cell SHC2 may be disposed between the first power interconnection line M1_R1 and the third power interconnection line M1_R3. The second single height cell SHC2 may be adjacent to the first single height cell SHC1 in the first direction D1.

The double height cell DHC may be disposed between the second power interconnection line M1_R2 and the third power interconnection line M1_R3. The double height cell DHC may be adjacent to the first single height cell SHC1 and the second single height cell SHC2 in a second direction D2.

An isolation structure DB may be provided between the first single height cell SHC1 and the double height cell DHC and between the second single height cell SHC2 and the double height cell DHC. An active region of the double height cell DHC may be electrically isolated from an active region of each of the first single height cell SHC1 and the second single height cell SHC2 by the isolation structure DB.

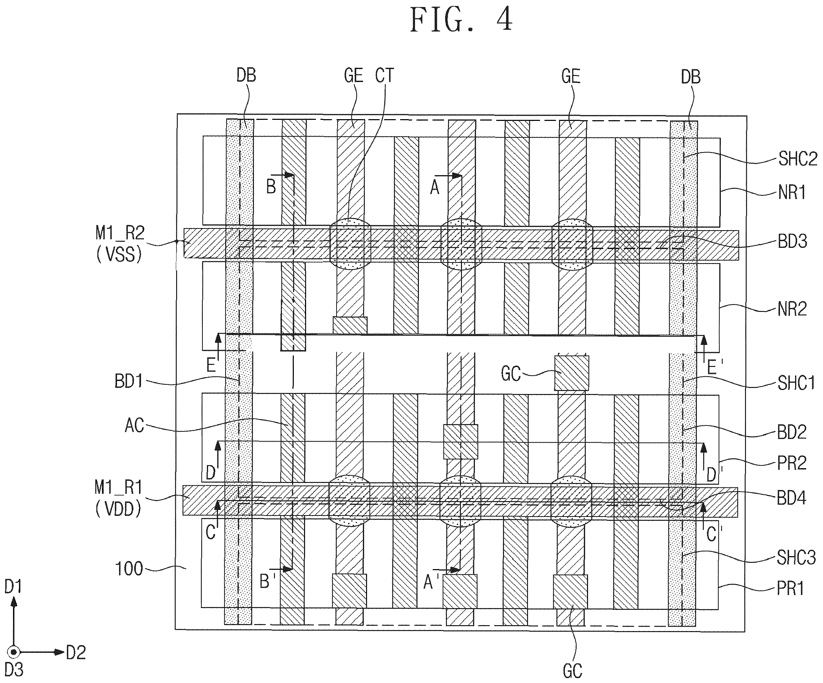

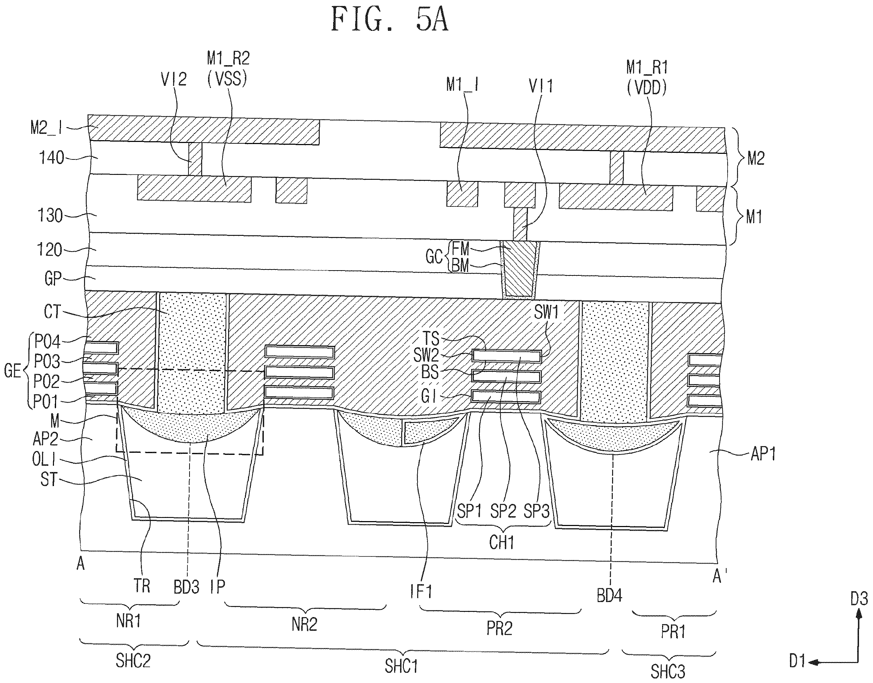

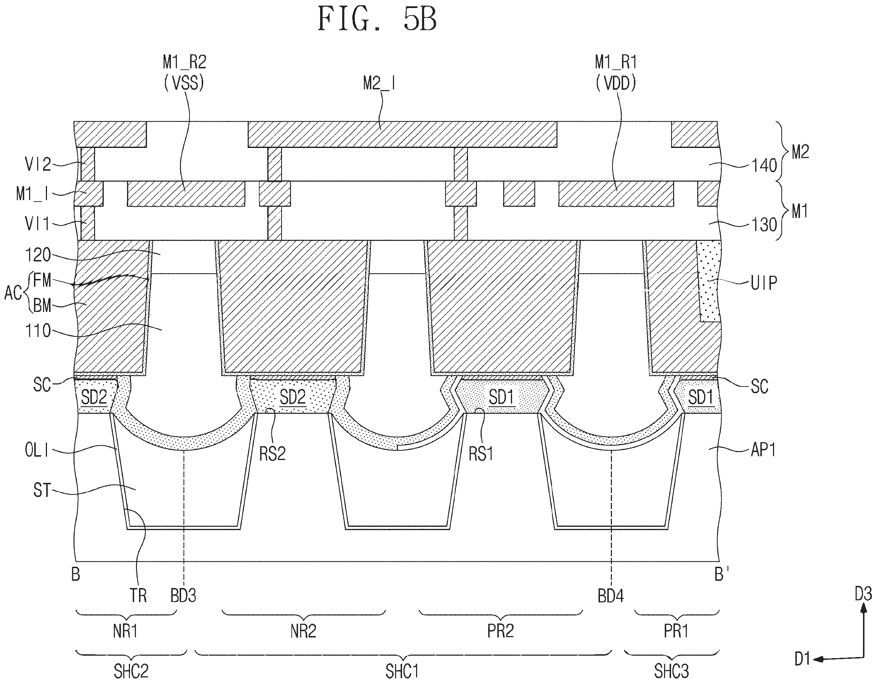

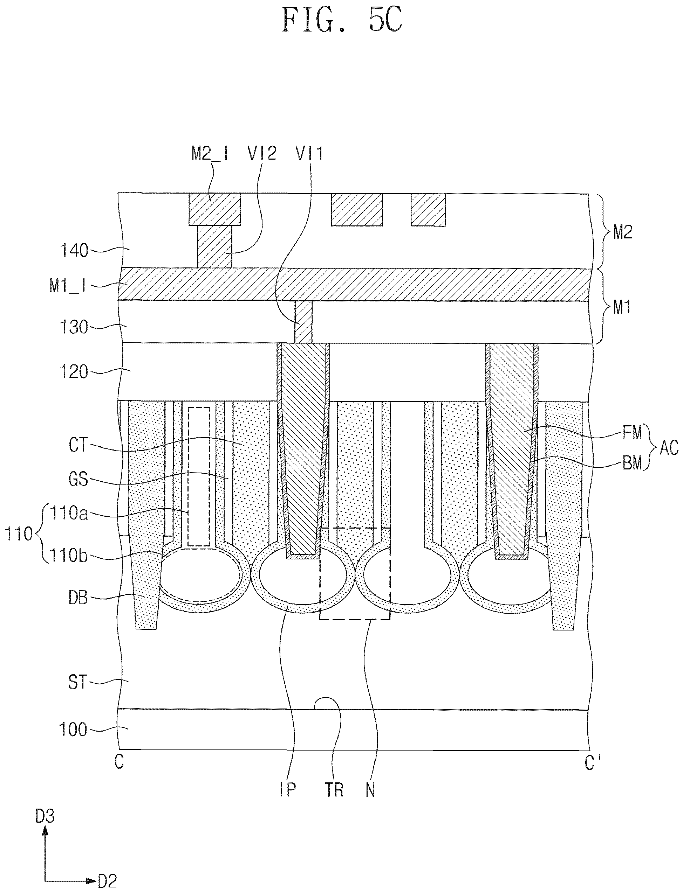

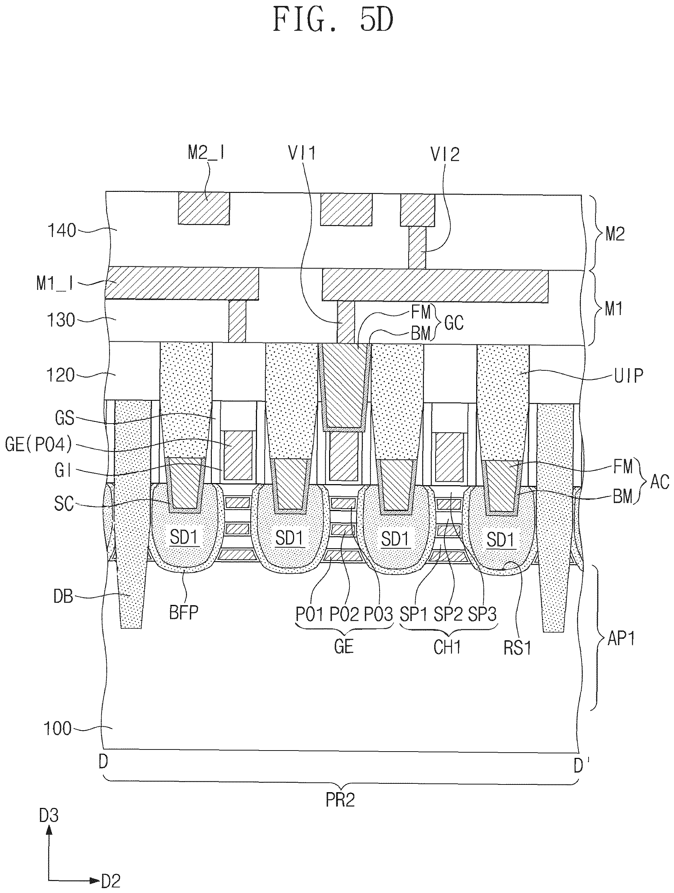

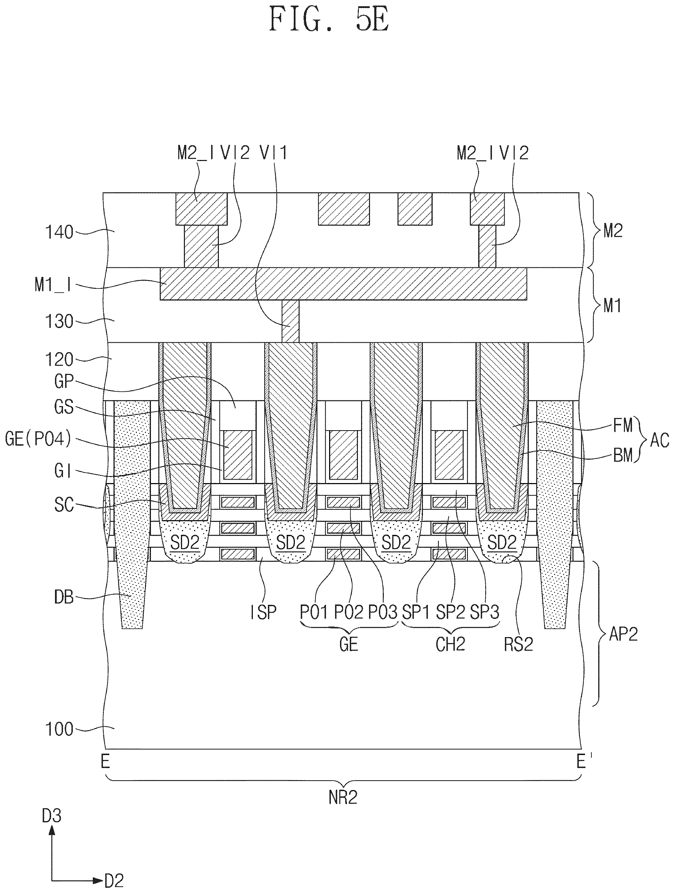

FIG. 4 is a plan view illustrating a semiconductor device according to some embodiments of the inventive concepts. FIG. 5A is a cross-sectional view taken along line A-A' of FIG. 4. FIG. 5B, is a cross-sectional view taken along line B-B' of FIG. 4. FIG. 5C is a cross-sectional view taken along line C-C' of FIG. 4. FIG. 5D is a cross-sectional view taken along line D-D' of FIG. 4. FIG. 5E is a cross-sectional view taken along line E-E' of FIG. 4.

A semiconductor device shown in FIG. 4, FIG. 5A, FIG. 5B, FIG. 5C, FIG. 5D, and FIG. 5E may be a semiconductor device in which the first single height cell SHC1, the second single height cell SHC2 and the third single height cell SHC3 are shown in more detail. The second single height cell SHC2 may be adjacent to the first single height cell SHC1 in the first direction D1. The third single height cell SHC3 may be adjacent to the first single height cell SHC1 in the first direction D1. The first single height cell SHC1 may be disposed between the second single height cell SHC2 and the third single height cell SHC3.

FIG. 4 illustrates the first single height cell SHC1 and portions of the second single height cell SHC2 and the third single height cell SHC3. Logic transistors constituting a logic circuit may be disposed on each of the first single height cell SHC1, the second single height cell SHC2 and the third single height cell SHC3. A substrate 100 may be a semiconductor substrate including silicon, germanium or silicon-germanium, or a compound semiconductor substrate. For example, the substrate 100 may be a silicon substrate.

The substrate 100 may include first active regions PR1 and PR2 and the second active regions NR1 and NR2. The first active regions PR1 and PR2 may include a first PMOSFET region PR1 and a second PMOSFET region PR2. The second active regions NR1 and NR2 may include a first NMOSFET region NR1 and a second NMOSFET region NR2. Each of the first PMOSFET region PR1, the second PMOSFET region PR2, the first NMOSFET region NR1 and the second NMOSFET region NR2 may extend in the second direction D2. The first single height cell SHC1 may include the second NMOSFET region NR2 and the second PMOSFET region PR2. The second single height cell SHC2 may include the first NMOSFET region NR1. The third single height cell SHC3 may include the first PMOSFET region PR1.

A first active pattern AP1 and a second active pattern AP2 may be defined by a trench TR formed in an upper portion of the substrate 100. The first active pattern AP1 may be provided on each of the first PMOSFET region PR1 and the second PMOSFET region PR2. The second active pattern AP2 may be provided on each of the first NMOSFET region NR1 and the second NMOSFET region NR2. The first active patterns AP1 and the second active pattern AP2 may extend in the second direction D2. The first active patterns AP1 and the second active pattern AP2 may be portions of the substrate 100. The first active patterns AP1 and the second active pattern AP2 may be portions of the substrate 100 that vertically protrude in a third direction D3.

A device isolation layer ST may fill the trench TR. The device isolation layer ST may include a silicon oxide layer. The device isolation layer ST may not cover a first channel pattern CH1 and a second channel pattern CH2 as described herein. The device isolation layer ST may include a concave top surface.

A liner layer OLI may be disposed between the device isolation layer ST and the first active pattern AP1 and the second active pattern AP2. The liner layer OLI may directly cover a sidewall of each of the first active pattern AP1 and the second active pattern AP2. In other words, the liner layer OLI may directly cover a sidewall of the trench TR. The liner layer OLI may directly cover a bottom of the trench TR. For example, the liner layer OLI may include a silicon oxide layer, a silicon nitride layer, or a combination thereof. In some embodiments of the inventive concepts, the liner layer OLI may include the same material as the device isolation layer ST, and in this case, a boundary between the liner layer OLI and the device isolation layer ST may not be visible.

A first channel pattern CH1 may be provided on the first active pattern AP1. A second channel pattern CH2 may be provided on the second active pattern AP2. Each of the first channel pattern CH1 and the second channel pattern CH2 may include a first semiconductor pattern SP1, a second semiconductor pattern SP2 and a third semiconductor pattern SP3. The first semiconductor pattern SP1, the second semiconductor pattern SP2, and the third semiconductor pattern SP3 may be sequentially stacked. The first semiconductor pattern SP1, the second semiconductor pattern SP2, and the third semiconductor pattern SP3 may be spaced apart from each other in a vertical direction (i.e., the third direction D3).

Each of the first semiconductor pattern SP1, the second semiconductor pattern SP2, and the third semiconductor pattern SP3 may include silicon (Si), germanium (Ge), or silicon-germanium (SiGe). For example, each of the first semiconductor pattern SP1, the second semiconductor pattern SP2, and the third semiconductor pattern SP3 may include crystalline silicon.

A plurality of first source/drain patterns SD1 may be provided on the first active pattern AP1 (see, for example, FIG. 5B). A plurality of first recesses RS1 may be formed on the first active pattern AP1. The first source/drain patterns SD1 may be provided in the first recesses RS1. The first source/drain patterns SD1 may be dopant regions having a first conductivity type (e.g., a p-type). The first channel pattern CH1 may be disposed between a pair of the first source/drain patterns SD1. In other words, the first semiconductor pattern SP1, the second semiconductor pattern SP2, and the third semiconductor pattern SP3 stacked sequentially may connect the source pattern and the drain pattern of the first source/drain patterns SD1 to each other.

A plurality of second source/drain patterns SD2 may be provided on the second active pattern AP2 (see, for example, FIG. 5B). A plurality of second recesses RS2 may be formed on the second active pattern AP2. The second source/drain patterns SD2 may be provided in the second recesses RS2. The second source/drain patterns SD2 may be dopant regions having a second conductivity type (e.g., an n-type). The second channel pattern CH2 may be disposed between a pair of the second source/drain patterns SD2. In other words, the first semiconductor pattern SP1, the second semiconductor pattern SP2, and the third semiconductor pattern SP3 stacked sequentially may connect the source pattern and the drain pattern of second source/drain patterns SD2 to each other.

The first source/drain patterns SD1 and the second source/drain patterns SD2 may be epitaxial patterns. The first source/drain patterns SD1 and the second source/drain patterns SD2 may be epitaxial patterns formed by a selective epitaxial growth (SEG) process. For example, a top surface of each of the first source/drain patterns SD1 and the second source/drain patterns SD2 may be located at substantially the same level as a top surface of the third semiconductor pattern SP3. Alternatively, the top surface of each of the first source/drain patterns SD1 and the second source/drain patterns SD2 may be higher than the top surface of the third semiconductor pattern SP3. A buffer pattern BFP may be provided on a sidewall and a bottom surface of the first source/drain pattern SD1. The buffer pattern BFP may include a semiconductor material (e.g., SiGe) having a germanium concentration decreasing from the first source/drain patterns SD1 toward the first active pattern AP1 and the first channel pattern CH1. The buffer pattern BFP may be in direct contact with the first channel pattern CH1. The buffer pattern BFP may be spaced apart from a gate electrode GE by a gate insulating layer GI (see, for example, FIG. 5D).

The first source/drain patterns SD1 may include a semiconductor element (e.g., SiGe) having a lattice constant greater than a lattice constant of a semiconductor element of the substrate 100. Thus, the pair of first source/drain patterns SD1 may provide compressive stress to the first channel pattern CH1 therebetween. The second source/drain patterns SD2 may include the same semiconductor element (e.g., Si) as the substrate 100.

Gate electrodes GE may be provided on the first channel pattern CH1 and the second channel pattern CH2. Each of the gate electrodes GE may intersect the first channel pattern CH1 and the second channel pattern CH2 and may extend in the first direction D1. Each of the gate electrodes GE may vertically overlap with the first channel pattern CH1 and the second channel pattern CH2. The gate electrodes GE may be arranged in the second direction D2 at a first pitch.

The gate electrode GE may include a first inner electrode PO1 disposed between the active pattern AP1 or AP2 and the first semiconductor pattern SP1, a second inner electrode PO2 disposed between the first semiconductor pattern SP1 and the second semiconductor pattern SP2, a third inner electrode PO3 disposed between the second semiconductor pattern SP2 and the third semiconductor pattern SP3, and an outer electrode PO4 on the third semiconductor pattern SP3.

Referring to FIG. 5A, the gate electrode GE may be provided on a top surface TS, a bottom surface BS, and sidewalls SW1 and SW2 of each of the first semiconductor pattern SP1, the second semiconductor pattern SP2, and the third semi conductor pattern SP3. In other words, a transistor according to the present embodiments may be a three-dimensional field effect transistor (e.g., a MBCFET or a GAAFET) in which the gate electrode GE three-dimensionally surrounds a channel.

Referring again to FIG. 4, the first single height cell SHC1 may have a first boundary BD1 and a second boundary BD2, which are opposite to each other in the second direction D2. The first boundary BD1 and the second boundary BD2 may extend in the first direction D1. The first single height cell SHC1 may have a third boundary BD3 and a fourth boundary BD4, which are opposite to each other in the first direction D1. The third boundary BD3 and the fourth boundary BD4 may extend in the second direction D2.

Gate cutting patterns CT may be disposed on the boundary in the second direction D2 of each of the first single height cell SHC1, the second single height cell SHC2, and the third single height cell SHC3. For example, the gate cutting patterns CT may be disposed on the third boundary BD3 and the fourth boundary BD4 of the first single height cell SHC1. The gate cutting patterns CT may be arranged along the third boundary BD3 at the first pitch. The gate cutting patterns CT may be arranged along the fourth boundary BD4 at the first pitch. The gate cutting patterns CT on the third boundary BD3 and the fourth boundary BD4 may overlap with the gate electrodes GE, respectively, when viewed in a plan view. The gate cutting patterns CT may include an insulating material such as silicon oxide, silicon nitride or a combination thereof.

The gate electrode GE on the first single height cell SHC1 may be separated from the gate electrode GE on the second single height cell SHC2 by the gate cutting pattern CT. The gate cutting patterns CT may be disposed between the gate electrode GE on the first single height cell SHC1 and the gate electrodes GE on the second single height cell SHC2 and the third single height cell SHC3, aligned thereto in the first direction D1. In other words, the gate electrode GE extending in the first direction D1 may be divided into a plurality of the gate electrodes GE by the gate cutting patterns CT.

Referring again to FIG. 4, FIG. 5A, FIG. 5B, FIG. 5C, FIG. 5D, and FIG. 5E, a pair of gate spacers GS may be disposed on both sidewalls of the outer electrode PO4 of the gate electrode GE, respectively (see, for example, FIG. 5D). The gate spacers GS may extend along the gate electrode GE in the first direction D1. Top surfaces of the gate spacers GS may be higher than a top surface of the gate electrode GE. The top surfaces of the gate spacers GS may be coplanar with a top surface of a first interlayer insulating layer 110 to be described herein. The gate spacers GS may include at least one of SiCN, SiCON, or SiN. For certain examples, each of the gate spacers GS may include a multi-layer formed of at least two of SiCN, SiCON, or SiN.

A gate capping pattern GP may be provided on the gate electrode GE. The gate capping pattern GP may extend along the gate electrode GE in the first direction D1. The gate capping pattern GP may include a material having an etch selectivity with respect to first interlayer insulating layer 110 and second interlayer insulating layer 120 to be described herein. For example, the gate capping pattern GP may include at least one of SiON, SiCN, SiCON, or SiN.

A gate insulating layer GI may be disposed between the gate electrode GE and the first channel pattern CH1 and between the gate electrode GE and the second channel pattern CH2. The gate insulating layer GI may cover the top surface TS, the bottom surface BS and the sidewalls SW1 and SW2 of each of the first semiconductor pattern SP1, the second semiconductor pattern SP2, and the third semiconductor pattern SP3. The gate insulating layer GI may cover a top surface of the device isolation layer ST under the gate electrode GE. The gate insulating layer GI may cover a sidewall of the gate cutting pattern CT (see, for example, FIG. 5A).

In some embodiments, the gate insulating layer GI may include a silicon oxide layer, a silicon oxynitride layer, and/or a high-k dielectric layer. The high-k dielectric layer may include a high-k dielectric material having a dielectric constant higher than a dielectric constant of a silicon oxide layer. For example, the high-k dielectric material may include at least one of hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, or lead zinc niobate.

In certain embodiments, the semiconductor device according to the inventive concepts may include a negative capacitance (NC) FET using a negative capacitor. For example, the gate insulating layer GI may include a ferroelectric material layer having ferroelectric properties, and a paraelectric material layer having paraelectric properties.

The ferroelectric material layer may have a negative capacitance, and the paraelectric material layer may have a positive capacitance. For example, when two or more capacitors are connected in series to each other and a capacitance of each of the capacitors has a positive value, a total capacitance may be reduced to be less than the capacitance of each of the capacitors. In a case when at least one of capacitances of two or more capacitors connected in series to each other has a negative value, a total capacitance may have a positive value and may be greater than an absolute value of the capacitance of each of the capacitors.

When the ferroelectric material layer having the negative capacitance is connected in series to the paraelectric material layer having the positive capacitance, a total capacitance value of the ferroelectric and paraelectric material layers connected in series may increase. A transistor including the ferroelectric material layer may have a subthreshold swing (SS) less than about 60 mV/decade at room temperature by using the increase in the total capacitance value.

The ferroelectric material layer may have the ferroelectric properties. For example, the ferroelectric material layer may include at least one of hafnium oxide, hafnium zirconium oxide, barium strontium titanium oxide, barium titanium oxide, or lead zirconium titanium oxide. Here, for an example, the hafnium zirconium oxide may be a material formed by doping hafnium oxide with zirconium (Zr). For another example, the hafnium zirconium oxide may be a compound of hafnium (Hf), zirconium (Zr), and oxygen (O).

The ferroelectric material layer may further include dopants doped therein. For example, the dopants may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), or tin (Sn). A kind of the dopants of the ferroelectric material layer may be changed depending on a kind of the ferroelectric material of the ferroelectric material layer.

When the ferroelectric material layer includes hafnium oxide, the dopants of the ferroelectric material layer may include at least one of, for example, gadolinium (Gd), silicon (Si), zirconium (Zr), aluminum (Al), or yttrium (Y).

When the dopants are aluminum (Al), the ferroelectric material layer may include aluminum of about 3 at% (atomic %) to 8 at%. Here, a ratio of the dopants may be a ratio of the amount of aluminum to a sum of the amounts of hafnium and aluminum.

When the dopants are silicon (Si), the ferroelectric material layer may include silicon of about 2 at% to 10 at%. When the dopants are yttrium (Y), the ferroelectric material layer may include yttrium of about 2 at% to 10 at%. When the dopants are gadolinium (Gd), the ferroelectric material layer may include gadolinium of about 1 at% to 7 at%. When the dopants are zirconium (Zr), the ferroelectric material layer may include zirconium of about 50 at% to 80 at%.

The paraelectric material layer may have the paraelectric properties. For example, the paraelectric material layer may include at least one of silicon oxide or a metal oxide having a high-k dielectric constant. For example, the metal oxide of the paraelectric material layer may include at least one of, but not limited to, hafnium oxide, zirconium oxide, or aluminum oxide.

The ferroelectric material layer and the paraelectric material layer may include the same material. The ferroelectric material layer may have ferroelectric properties, and the paraelectric material layer may not have ferroelectric properties. For example, when the ferroelectric material layer and the paraelectric material layer include hafnium oxide, a crystal structure of hafnium oxide of the ferroelectric material layer may be different from a crystal structure of hafnium oxide of the paraelectric material layer.

A thickness of the ferroelectric material layer may affect its ferroelectric properties. The thickness of the ferroelectric material layer may be selected to tune the ferroelectric properties thereof. For example, the thickness of the ferroelectric material layer may range from about 0.5nm to 10nm, but embodiments of the inventive concepts are not limited thereto. A relationship between the thickness of a ferroelectric material and its ferroelectric properties may depend on the ferroelectric material, and thus the thickness of the ferroelectric material layer may be changed depending on the ferroelectric material used.

For some examples, the gate insulating layer GI may include a single ferroelectric material layer. For other examples, the gate insulating layer GI may include a plurality of the ferroelectric material layers spaced apart from each other. The gate insulating layer GI may have a stacked structure in which the ferroelectric material layers and the paraelectric material layers are alternately stacked.

Referring again to FIG. 4, FIG. 5A, FIG. 5B, FIG. 5C, FIG. 5D, and FIG. 5E, the gate electrode GE may include a first metal pattern and a second metal pattern on the first metal pattern. The first metal pattern may be provided on the gate insulating layer GI and may be adjacent to the first semiconductor pattern SP1, the second semiconductor pattern SP2, and the third semiconductor pattern SP3. The first metal pattern may include a work function metal of adjusting a threshold voltage of a transistor. A desired threshold voltage of the transistor may be obtained by adjusting a thickness and a composition of the first metal pattern. For example, the first inner electrode PO1, the second inner electrode PO2, and the third inner electrode PO3 of the gate electrode GE may be formed of the first metal pattern corresponding to the work function metal.

The first metal pattern may include a metal nitride layer. For example, the first metal pattern may include nitrogen (N) and at least one of titanium (Ti), tantalum (Ta), aluminum (Al), tungsten (W), or molybdenum (Mo). In addition, the first metal pattern may further include carbon (C). In some embodiments, the first metal pattern may include a plurality of stacked work function metal layers.

The second metal pattern may include a metal having a resistance lower than a resistance of the first metal pattern. For example, the second metal pattern may include at least one of tungsten (W), aluminum (Al), titanium (Ti), or tantalum (Ta). For example, the outer electrode PO4 of the gate electrode GE may include the first metal pattern and the second metal pattern on the first metal pattern.

A first interlayer insulating layer 110 may be provided on the substrate 100. The first interlayer insulating layer 110 may cover the gate spacers GS and the first source/drain patterns SD1 and the second source/drain patterns SD2. More particularly, the first interlayer insulating layer 110 may directly cover a top surface of an insulating pattern IP described herein. A top surface of the first interlayer insulating layer 110 may be substantially coplanar with the top surface of the gate capping pattern GP and the top surface of the gate spacer GS (see, for example, FIG. 5A and FIG. 5C). A second interlayer insulating layer 120 covering the gate capping pattern GP may be disposed on the first interlayer insulating layer 110. A third interlayer insulating layer 130 may be provided on the second interlayer insulating layer 120. A fourth interlayer insulating layer 140 may be provided on the third interlayer insulating layer 130. For example, each of the first interlayer insulating layer 110, second interlayer insulating layers 120, third interlayer insulating layers 130, and fourth interlayer insulating layer 140 may include a silicon oxide layer.

Each of the first single height cell SHC1, the second single height cell SHC2, and the third single height cell SHC3 may have the first boundary BD1 and the second boundary BD2, which are opposite to each other in the second direction D2. The first boundary BD1 and the second boundary BD2 may extend in the first direction D1. Each of the first single height cell SHC1, the second single height cell SHC2, and the third single height cell SHC3 may have the third boundary BD3 and the fourth boundary BD4, which are opposite to each other in the first direction D1. The third boundary BD3 and the fourth boundary BD4 may extend in the second direction D2.

A pair of isolation structures DB opposite to each other in the second direction D2 may be provided at both sides of the first single height cell SHC1, the second single height cell SHC2, and the third single height cell SHC3. For example, the pair of isolation structures DB may be provided on the first boundary BD1 and the second boundary BD2 of the first single height cell SHC1, the second single height cell SHC2, and the third single height cell SHC3. The isolation structure DB may extend in the first direction D1 in parallel to the gate electrode GE. A pitch between the isolation structure DB and the gate electrode GE adjacent thereto may be equal to the first pitch.

The isolation structure DB may penetrate the first interlayer insulating layer 110. For example, the isolation structure DB may contact a lower surface of the second interlayer insulating layer 120 (see, for example, FIG. 5E). The isolation structure DB may penetrate the second interlayer insulating layer 120. The isolation structure DB may extend into the first active pattern AP1 and the second active pattern AP2. The isolation structure DB may penetrate an upper portion of each of the first active pattern AP1 and the second active pattern AP2. The isolation structure DB may electrically isolate the active regions of the first single height cell SHC1, the second single height cells SHC2, and the third single height cell SHC3 from active regions of other cells adjacent thereto.

Active contacts AC may penetrate the first interlayer insulating layer 110 and the second interlayer insulating layer 120. The active contacts AC may be electrically connected to the first source/drain patterns SD1 and the second source/drain pattern SD2. A pair of the active contacts AC may be provided on opposite sides of the gate electrode GE, respectively. The active contact AC may have a bar shape extending in the first direction D1 when viewed in a plan view.

The active contact AC may be a self-aligned contact. In other words, the active contact AC may be formed to be self-aligned with the gate capping pattern GP and the gate spacer GS. For example, the active contact AC may cover at least a portion of a sidewall of the gate spacer GS. Even though not shown in the drawings, the active contact AC may cover a portion of the top surface of the gate capping pattern GP.

Metal-semiconductor compound layers SC (e.g., silicide layers) may be disposed between the active contact AC and the first source/drain patterns SD1, and between the active contact AC and the second source/drain pattern SD2. The active contact AC may be electrically connected to the first source/drain patterns SD1 or the second source/drain patterns SD2 through the metal-semiconductor compound layer SC. For example, the metal-semiconductor compound layer SC may include at least one of titanium silicide, tantalum silicide, tungsten silicide, nickel silicide, or cobalt silicide.

Gate contacts GC may penetrate the second interlayer insulating layer 120 and the gate capping patterns GP. Gate contacts GC may be electrically connected to the gate electrodes GE, respectively. At least some of the gate contacts GC may overlap with the PMOSFET and NMOSFET regions PR1, PR2, NR1 and NR2, respectively, when viewed in a plan view. For example, the gate contact GC may be provided on the first active pattern AP1 (see, for example, FIG. 5D).

In some embodiments, and referring to FIG. 5D, an upper insulating pattern UIP may be disposed on an upper portion of the active contact AC. The upper portion of the active contact AC adjacent to the gate contact GC may be filled with the upper insulating pattern UIP. A bottom surface of the upper insulating pattern UIP may be lower than a bottom surface of the gate contact GC. In other words, a top surface of the active contact AC adjacent to the gate contact GC may be lower than the bottom surface of the gate contact GC. The upper insulating pattern UIP may prevent an electrical short between the gate contact GC and the active contact AC adjacent thereto.

Each of the active contact AC and the gate contact GC may include a conductive pattern FM and a barrier pattern BM surrounding the conductive pattern FM. For example, the conductive pattern FM may include at least one metal of aluminum, copper, tungsten, molybdenum, or cobalt. The barrier pattern BM may cover sidewalls and a bottom surface of the conductive pattern FM. The barrier pattern BM may include a metal layer/a metal nitride layer. The metal layer may include at least one of titanium, tantalum, tungsten, nickel, cobalt, or platinum. The metal nitride layer may include at least one of a titanium nitride (TiN) layer, a tantalum nitride (TaN) layer, a tungsten nitride (WN) layer, a nickel nitride (NiN) layer, a cobalt nitride (CoN) layer, or a platinum nitride (PtN) layer.

A first metal layer M1 may be provided in the third interlayer insulating layer 130. For example, the first metal layer M1 may include a first power interconnection line M1_R1, a second power interconnection line M1_R2, and first interconnection lines M1_I. The first power interconnection line M1_R1, the second power interconnection line M1_R2 and the first interconnection line M1_I of the first metal layer M1 may extend in the second direction D2 in parallel to each other.

More particularly, the first power interconnection line M1_R1 and the second power interconnection line M1_R2 may be provided on the third boundary BD3 and the fourth boundary BD4 of the first single height cell SHC1, respectively. The first power interconnection line M1_R1 may extend in the second direction D2 along the fourth boundary BD4. The second power interconnection line M1_R2 may extend in the second direction D2 along the third boundary BD3.

The first interconnection lines M1_I of the first metal layer M1 may be disposed between the first power interconnection line M1_R1 and the second power interconnection line M1_R2. The first interconnection lines M1_I of the first metal layer M1 may be arranged in the first direction D1 at a second pitch. The second pitch may be less than the first pitch. A line width of each of the first interconnection lines M1_I may be less than a line width of each of the first power interconnection line M1_R1 and the second power interconnection line M1_R2.

The first metal layer M1 may further include first vias VI1. The first vias VI1 may be disposed under the first interconnection line M1_R1, the second interconnection line M1_R2 and the first interconnection line M1_I of the first metal layer M1. The active contact AC and a corresponding interconnection line of the first metal layer M1 may be electrically connected to each other through a corresponding first via of the first vias VI1. The gate contact GC and a corresponding interconnection line of the first metal layer M1 may be electrically connected to each other through a corresponding first via of the first vias VI1.

The interconnection line of the first metal layer M1 and the first via VI1 thereunder may be formed using different processes. In other words, each of the interconnection line and the first via VI1 of the first metal layer M1 may be formed using a single damascene process. The semiconductor device according to the present embodiments may be formed using processes less than about 20nm.

A second metal layer M2 may be provided in the fourth interlayer insulating layer 140. The second metal layer M2 may include a plurality of second interconnection lines M2_I. Each of the second interconnection lines M2_I of the second metal layer M2 may have a line shape or bar shape extending in the first direction D1. In other words, the second interconnection lines M2_I may extend in the first direction D1 in parallel to each other.

The second metal layer M2 may further include second vias VI2 disposed under the second interconnection lines M2_I. A corresponding interconnection line of the first metal layer M1 may be electrically connected to a corresponding interconnection line of the second metal layer M2 through a corresponding second via of the second vias VI2. For example, the interconnection line of the second metal layer M2 and the second via VI2 thereunder may be formed together by a dual damascene process.

The interconnection line of the first metal layer M1 and the interconnection line of the second metal layer M2 may include the same conductive material or different conductive materials. The interconnection line of the first metal layer M1 and the interconnection line of the second metal layer M2 may include a metal material. For example, the interconnection line of the first metal layer M1 and the interconnection line of the second metal layer M2 may include at least of aluminum, copper, tungsten, molybdenum, ruthenium, or cobalt. Even though not shown in the drawings, metal layers (e.g., M3, M4, M5, ...) stacked on the fourth interlayer insulating layer 140 may be additionally provided. Each of the stacked metal layers may include interconnection lines for routing between cells.

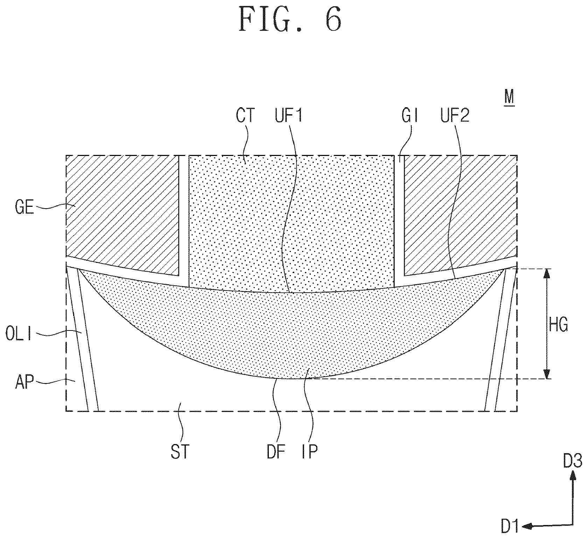

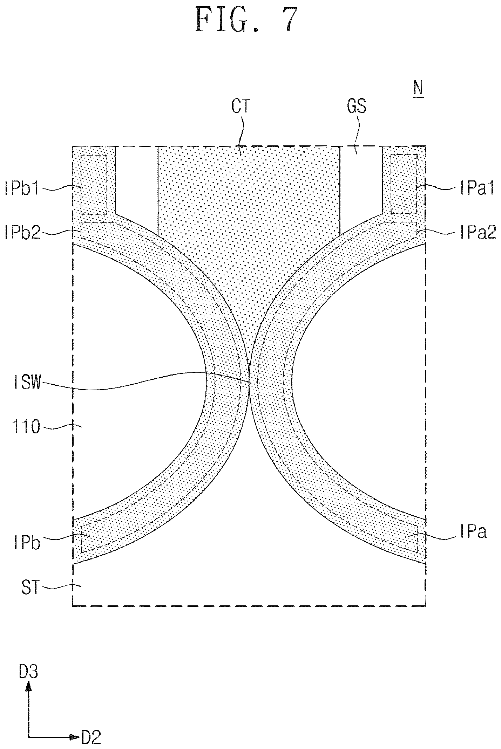

The device isolation layer ST and the gate cutting pattern CT will be described in more detail with reference to FIG. 6 and FIG. 7.

FIG. 6 is an enlarged view of a region 'M' of FIG. 5A. A semiconductor device according to the inventive concepts may include an insulating pattern IP between the gate cutting pattern CT and the top surface of the device isolation layer ST. The top surface of the device isolation layer ST may have a concave shape. In addition, the insulating pattern IP may also be disposed between the gate electrode GE and the device isolation layer ST.

A top surface of the insulating pattern IP and a bottom surface DF of the insulating pattern IP may be curved surfaces. More particularly, the insulating pattern IP may be disposed on the concave top surface of the device isolation layer ST and thus the bottom surface DF of the insulating pattern IP may have a convex shape. The top surface of the insulating pattern IP may have a different curvature than the bottom surface DF of the insulating pattern IP. The insulating pattern IP may have a half moon-shaped profile. The insulating pattern IP may have an uppermost portion and a lowermost portion. Here, a vertical distance HG between the uppermost portion and the lowermost portion may range from about 5nm to 50nm. The insulating pattern IP may include an insulating material. More particularly, the insulating pattern IP may include at least one of SiN, SiCN, SiOC, or SiOCN.

The top surface of the insulating pattern IP may include a first top surface UF1 in contact with the gate cutting pattern CT. In certain embodiments, the insulating pattern IP may include a void VS. In this case, due to the void VS, the insulating pattern IP may not be in direct contact with the gate cutting pattern CT. The gate insulating layer GI may cover another portion UF2 of the top surface of the insulating pattern IP.

Since the insulating pattern IP may be disposed between the top surface of the device isolation layer ST and the gate cutting pattern CT, it may be possible to prevent the gate electrode GE and the gate cutting pattern CT from being formed deeply toward the top surface of the device isolation layer ST. Thus, the insulating pattern IP may prevent a capacitor/gate leakage current from increasing by contact between the gate electrode GE and the active pattern AP. In addition, the insulating pattern IP may adjust a depth of the gate cutting pattern CT to prevent the gate cutting pattern CT from being in contact with the active pattern AP.

FIG. 7 is an enlarged view of a region 'N' of FIG. 5C.

Referring to FIG. 5C and FIG. 7, the insulating pattern IP may be disposed between the device isolation layer ST and the first interlayer insulating layer 110 and between the gate spacer GS and the first interlayer insulating layer 110. In other words, the insulating pattern IP may surround the first interlayer insulating layer 110. Here, the insulating pattern IP may include a first portion IPa1 and IPb1 and a second portion IPa2 and IPb2. The first portion IPa1 and IPb1 may be a portion of the insulating pattern IP, which may be disposed between the first interlayer insulating layer 110 and the gate spacer GS. The second portion IPa2 and IPb2 may be another portion of the insulating pattern IP, which may be disposed between the first interlayer insulating layer 110 and the device isolation layer ST. The second portion IPa2 and IPb2 may be disposed in the device isolation layer ST. The second portion IPa2 and IPb2 may have a round profile when viewed in a cross-sectional view.

The first interlayer insulating layer 110 may include a first interlayer insulating layer portion 110a and a second interlayer insulating layer portion 110b. The second interlayer insulating layer portion 110b may be disposed in the device isolation layer ST. The second portion IPa2 and IPb2 may have a round profile when viewed in a cross-sectional view. The first portion IPa1 of the insulating pattern IP may be disposed on a sidewall of the first interlayer insulating layer portion 110a. The second portion IPa2 of the insulating pattern IP may cover the second interlayer insulating layer portion 110b.

The insulating pattern IP may include a first insulating pattern IPa and a second insulating pattern IPb. The first insulating pattern IPa and the second insulating pattern IPb may be spaced apart from each other with the gate cutting pattern CT interposed therebetween. The second portion IPa2 of the first insulating pattern IPa may include a first sidewall ISW. Here, the first sidewall ISW may be in contact with the second portion IPb2 of the second insulating pattern IPb. In other words, the second portion IPa2 of the first insulating pattern IPa may be in contact with the second portion IPb2 of the second insulating pattern IPb.

A portion of the insulating pattern IP may be in contact with the gate cutting pattern CT. The second portion IPa2 and IPb2 may be in contact with the gate cutting pattern CT and the gate spacer GS. A cross-sectional view taken along the first sidewall ISW may be the same as FIG. 6, and as shown in FIG. 6, the gate cutting pattern CT may be in contact with the insulating pattern IP. Even though not shown in the drawings, in certain embodiments of the inventive concepts, the insulating pattern IP may include the void VS. Thus, the void VS may exist between the insulating pattern IP and the gate cutting pattern CT.

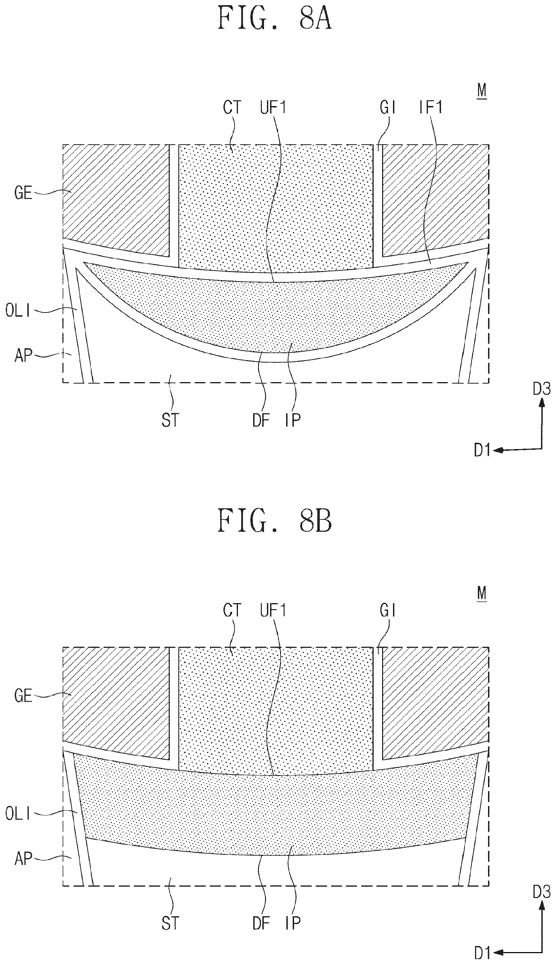

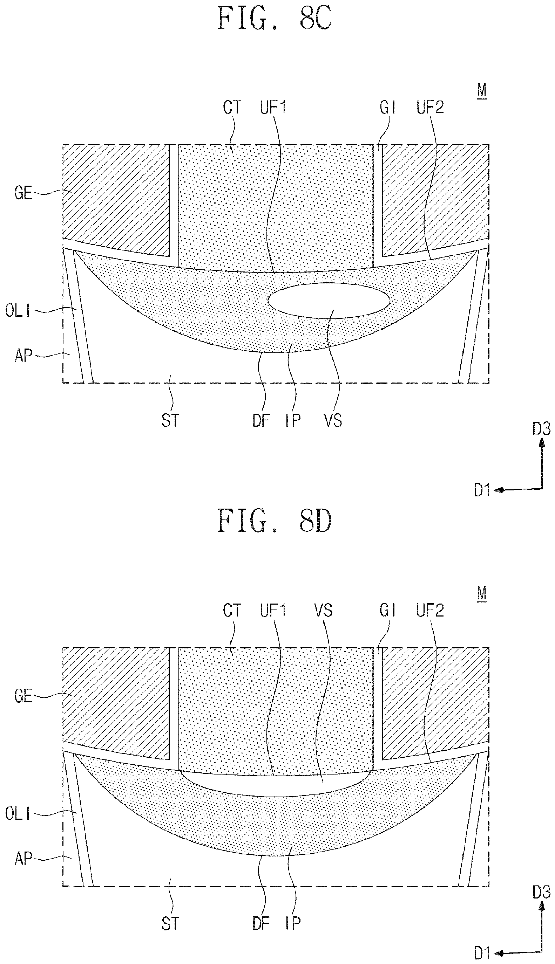

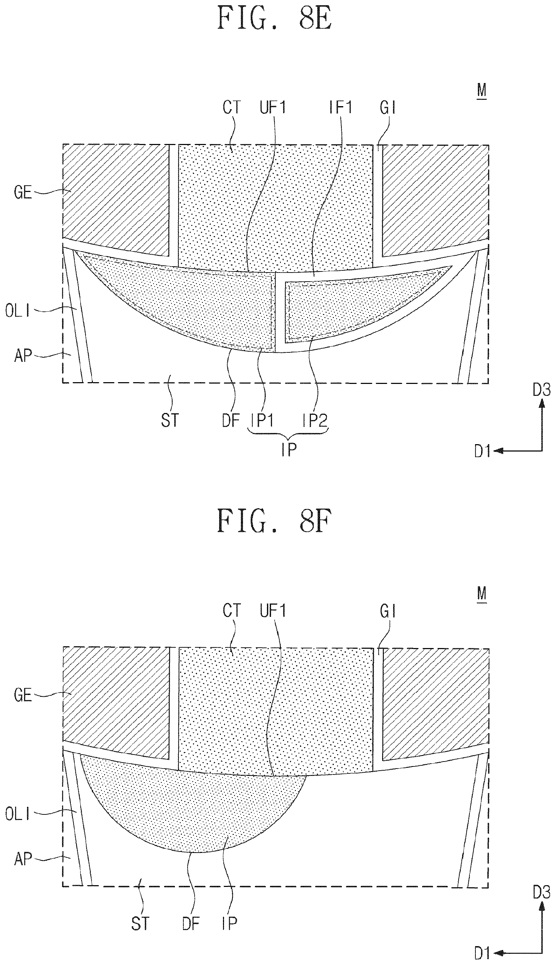

FIG. 8A, FIG. 8B, FIG. 8C, FIG. 8D, FIG. 8E and FIG. 8F are enlarged views corresponding to the region 'M' of FIG. 5A to illustrate semiconductor devices according to some embodiments of the inventive concepts.

Referring to FIG. 8A, a first insulating layer IF1 may be disposed on the top surface of the insulating pattern IP. The first insulating layer IF1 may separate the insulating pattern IP from the gate cutting pattern CT. That is, the insulating pattern IP may be in direct contact with the gate cutting pattern CT. Even though not shown in the drawings, a void VS may be formed between the insulating pattern IP and the first insulating layer IF1. The first insulating layer IF1 may also be disposed between the bottom surface DF of the insulating pattern IP and the device isolation layer ST. Referring to FIG. 8B, a sidewall of the insulating pattern IP may be in contact with the liner layer OLI covering a sidewall of the active pattern AP. Even though not shown in the drawings, the sidewall of the insulating pattern IP may be in direct contact with the active pattern AP.

Referring to FIG. 8C and FIG. 8D, the insulating pattern IP may include a void VS. The insulating pattern IP may include a plurality of the voids VS. In certain embodiments, due to the void VS, portions of the top surface of the insulating pattern IP may not be in contact with the gate cutting pattern CT, the gate insulating layer GI, or the gate electrode GE. The void VS may be generated in a process of filling an empty space ES, formed in a manufacturing process described herein, with the insulating pattern IP.

Referring to FIG. 8E, an insulating pattern IP may include a first insulating portion IP1 and a second insulating portion IP2. The first insulating portion IP1 may be spaced apart from the second insulating portion IP2 by the first insulating layer IF1. This may be because the PMOSFET regions PR1 and PR2 and the NMOSFET regions NR1 and NR2 are sequentially patterned in a manufacturing process described herein. The first insulating portion IP1 may be in contact with the gate cutting pattern CT. The first insulating layer IF1 may surround the second insulating portion IP2. The second insulating portion IP2 may be formed on the PMOSFET region PR1 or PR2. Even though not shown in the drawings, the first insulating portion IP1 and the second insulating portion IP2 may include voids VS.

Referring to FIG. 8F, a portion of the first top surface UF1 of the insulating pattern IP may be in contact with a portion of the gate cutting pattern CT. The bottom surface DF of the insulating pattern IP may be surrounded by the device isolation layer ST. Even though not shown in the drawings, the insulating pattern IP may not be in contact with the gate insulating layer GI. The insulating pattern IP may be variously formed as shown in FIGS. 8A to 8F.

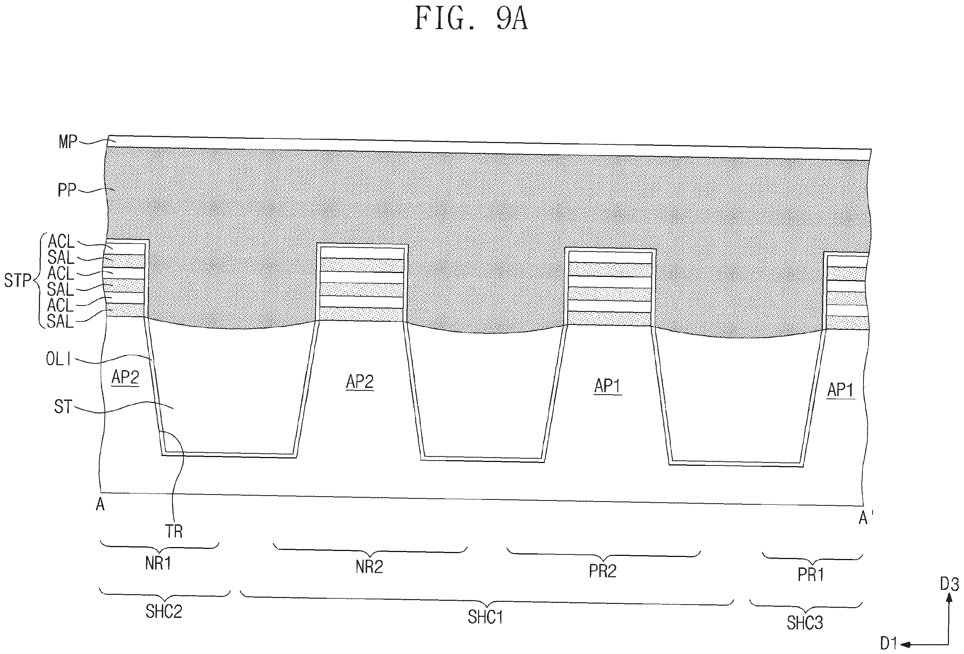

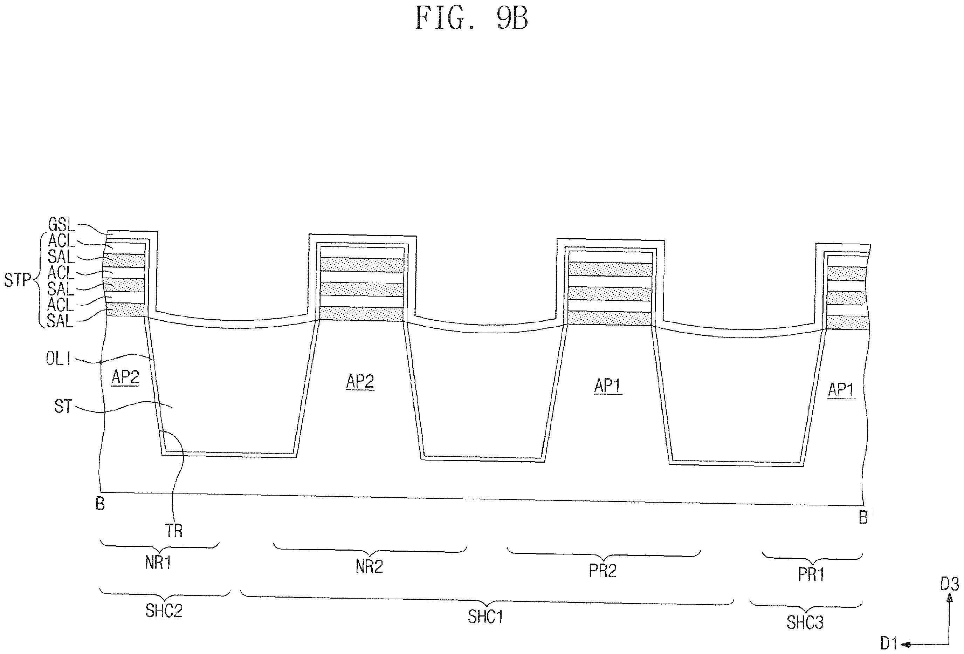

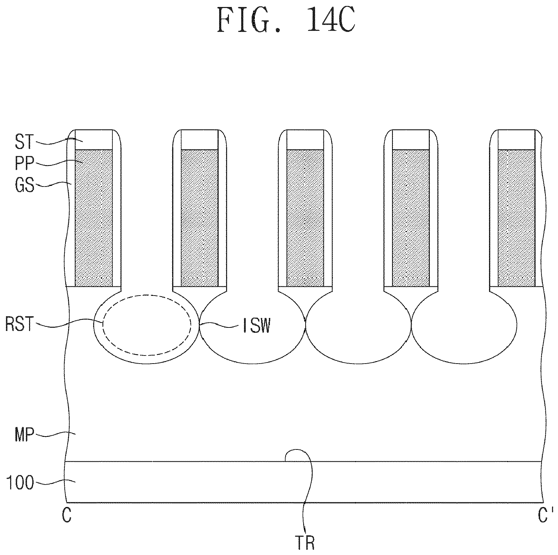

FIGS. 9A to 17 are cross-sectional views illustrating a method of manufacturing a semiconductor device according to some embodiments of the inventive concepts. FIG. 9A, FIG. 11A, FIG. 12A, FIG. 14A and FIG. 15A are cross-sectional views taken along the line A-A' of FIG. 4. FIG. 9B, FIG. 10, FIG. 11B, FIG. 12B, FIG. 13, FIG. 14B and FIG. 15B are cross-sectional views taken along the line B-B' of FIG. 4. FIG. 14C, FIG. 15C, FIG. 16 and FIG. 17 are cross-sectional views taken along the line C-C' of FIG. 4.

Referring to FIG. 9A and FIG. 9B, a substrate 100 having a first PMOSFET region PR1 and a second PMOSFET region PR2 and a first NMOSFET region NR1 and a second NMOSFET region NR2 may be provided. The second NMOSFET region NR2 and the second PMOSFET region PR2 may define a first single height cell SHC1. A second single height cell SHC2 may include the first NMOSFET region NR1, and a third single height cell SHC3 may include the first PMOSFET region PR1.

Sacrificial layers SAL and active layers ACL may be alternately formed on the substrate 100. The sacrificial layers SAL may include one of silicon (Si), germanium (Ge) or silicon-germanium (SiGe), and the active layers ACL may include another of silicon (Si), germanium (Ge) or silicon-germanium (SiGe).

For example, the sacrificial layers SAL may include silicon-germanium (SiGe), and the active layers ACL may include silicon (Si). A concentration of germanium (Ge) of each of the sacrificial layers SAL may range from about 10 at% to 30 at%.

The substrate 100 may be patterned to form trenches TR defining first active pattern AP1 and second active pattern AP2. The first active patterns AP1 may be formed on the first PMOSFET region PR1 and the second PMOSFET region PR2, respectively. The second active patterns AP2 may be formed on the first NMOSFET region NR1 and the second NMOSFET region NR2, respectively.

A stack pattern STP may be formed on each of the first active pattern AP1 and the second active pattern AP2. The stack pattern STP may include the sacrificial layers SAL and the active layers ACL, which are alternately stacked. A liner layer OLI may be disposed on the trenches TR and the stack patterns STP. In other words, the liner layer OLI may cover inner surfaces of the trenches TR and top surfaces and sidewalls of the stack patterns STP (see, for example, FIG. 9A).

A device isolation layer ST filling the trench TR may be formed. For example, an insulating layer covering the first active pattern AP1 and the second active pattern AP2 and the stack patterns STP may be formed on an entire top surface of the substrate 100. The insulating layer may be recessed. The insulating layer may be recessed until the stack patterns STP are exposed, thereby forming the device isolation layer ST. The device isolation layer ST may include an insulating material (e.g., silicon oxide). The stack patterns STP may be exposed above the device isolation layer ST. In other words, the stack patterns STP may vertically protrude above the device isolation layer ST.

Sacrificial patterns PP may be formed to intersect the first active pattern AP1 and the second active pattern AP2. The sacrificial patterns PP may have line shapes or bar shapes extending in the first direction D1.

For example, the formation of the sacrificial patterns PP may include forming a sacrificial pattern layer on a top surface of the substrate 100, forming mask patterns MP on the sacrificial pattern layer, and patterning the sacrificial pattern layer using the mask patterns MP as etch masks. The sacrificial pattern layer may be formed on an entire top surface of the substrate 100. The sacrificial pattern layer may include poly-silicon.

Referring to FIG. 9B, a gate spacer layer GSL may cover a top surface of the device isolation layer ST. The gate spacer layer GSL may cover the sidewalls and the top surfaces of the stack patterns STP. The gate spacer layer GSL may include an insulating material. For example, the gate spacer layer GSL may include at least one of SiOCN, SiCN, or SiN. The gate spacer layer GSL may be etched to form a pair of gate spacers GS on both sidewalls of each of the sacrificial patterns PP.

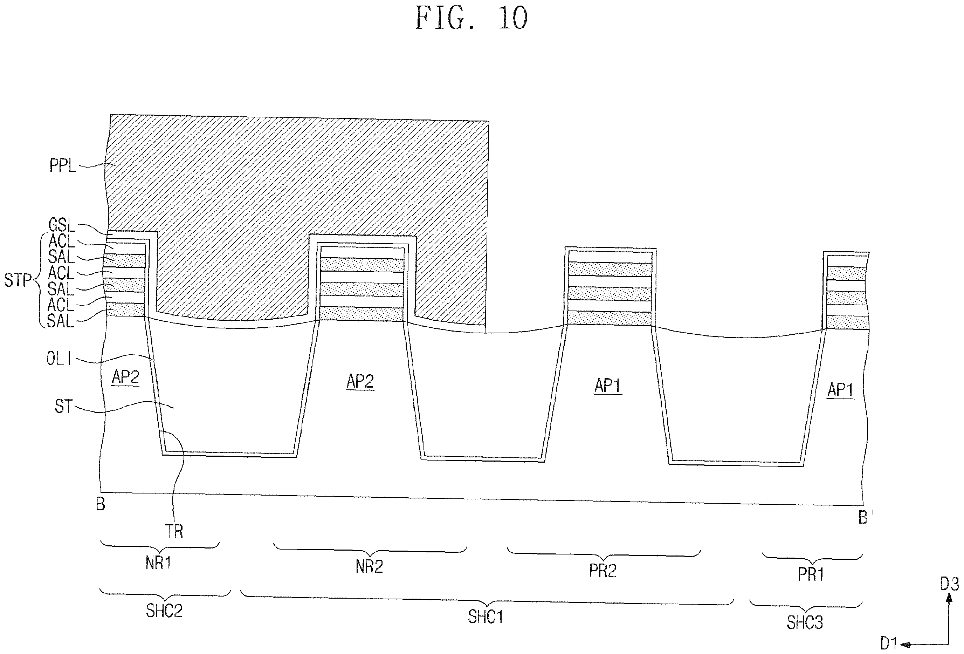

Referring to FIG. 10, a sacrificial layer PPL may be formed on the first NMOSFET region NR1 and the second NMOSFET region NR2. To form the sacrificial layer PPL, a sacrificial layer PPL may be coated on the first NMOSFET region NR1 and the second NMOSFET region NR2 and the first PMOSFET region PR1 and the second PMOSFET region PR2. A mask pattern covering the first NMOSFET region NR1 and the second NMOSFET region NR2 may be formed on the coated sacrificial layer PPL. An etching process may be performed using the mask pattern as an etch mask to remove the sacrificial layer PPL and the gate spacer layer GSL on the first and second PMOSFET regions PR1 and PR2. On the other hand, the sacrificial layer PPL and the gate spacer layer GSL on the first NMOSFET region NR1 and the second NMOSFET region NR2 may not be removed and may remain.

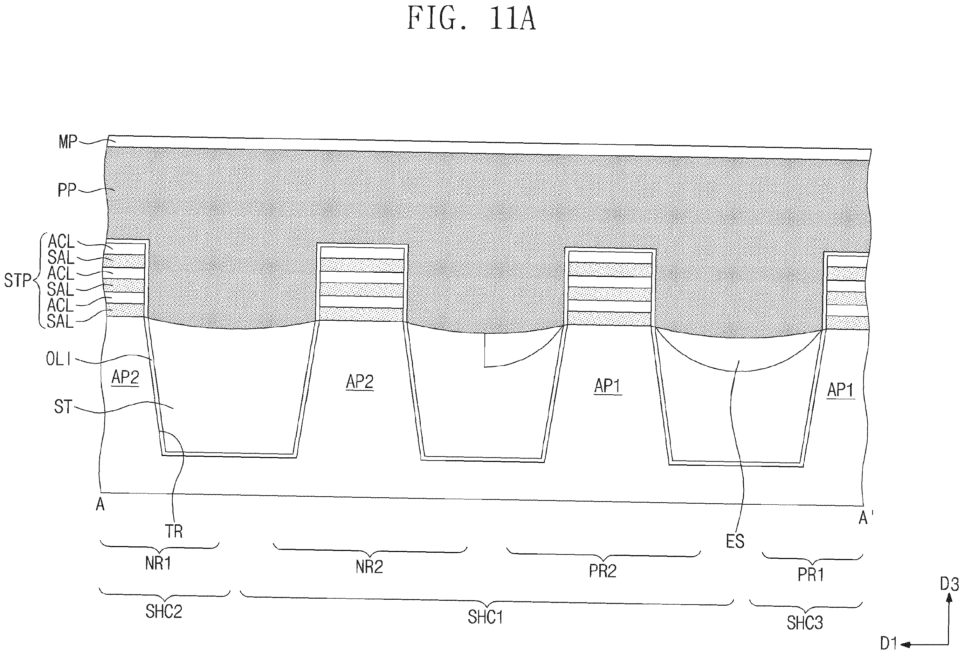

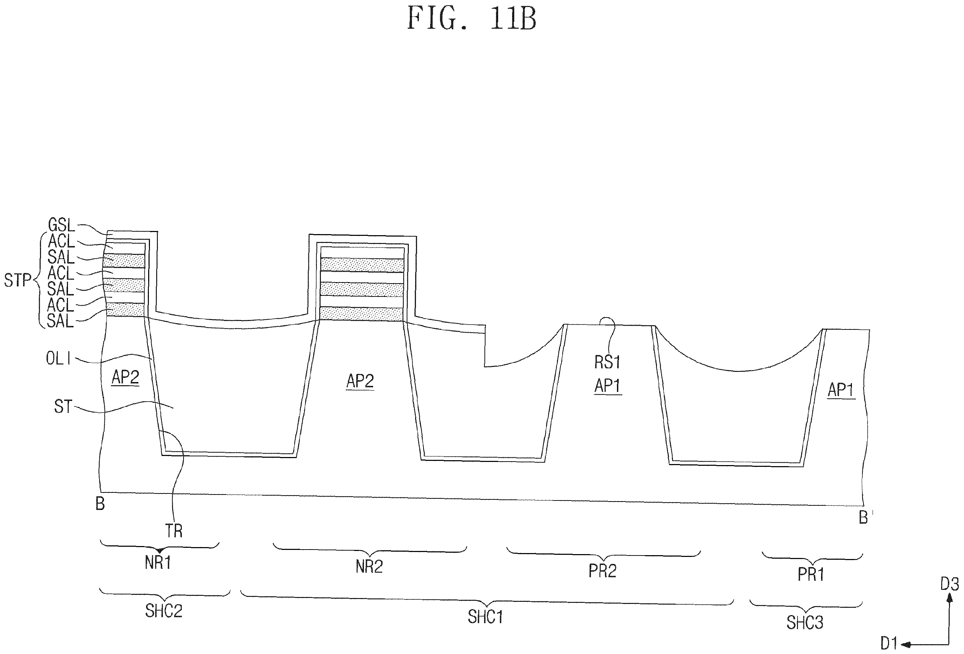

Referring to FIG. 11A and FIG. 11B, the device isolation layer ST on the first PMOSFET region PR1 and the second PMOSFET region PR2 may be etched using the sacrificial layer PPL as an etch mask. In addition, portions of the stack patterns STP on the first PMOSFET region PR1 and the second PMOSFET region PR2 may be removed to form first recesses RS1. A depth of the etched device isolation layer ST may range from about 2nm to 60nm.

The etched device isolation layer ST may have a half moon-shaped profile when viewed in a cross-sectional view or may have at least one of the various profiles shown in embodiments of FIG. 8A, FIG. 8B, FIG. 8C, FIG. 8D, FIG. 8E, and FIG. 8F. In the first single height cell SHC1, a portion of the device isolation layer ST located on a boundary between the second NMOSFET region NR2 and the second PMOSFET region PR2 may be etched. A portion of the etched device isolation layer ST may be located on the second PMOSFET region PR2. Thereafter, the sacrificial layer PPL on the first NMOSFET region NR1 and the second NMOSFET region NR2 may be removed.

Referring to FIG. 11A, an empty space ES may be formed between the sacrificial pattern PP and the etched device isolation layer ST. The empty space ES may include an uppermost portion and a lowermost portion. A vertical distance between the uppermost portion and the lowermost portion of the empty space ES may be equal to or less than the depth of the etched device isolation layer ST. The vertical distance between the uppermost portion and the lowermost portion of the empty space ES may range from about 2nm to 60nm.

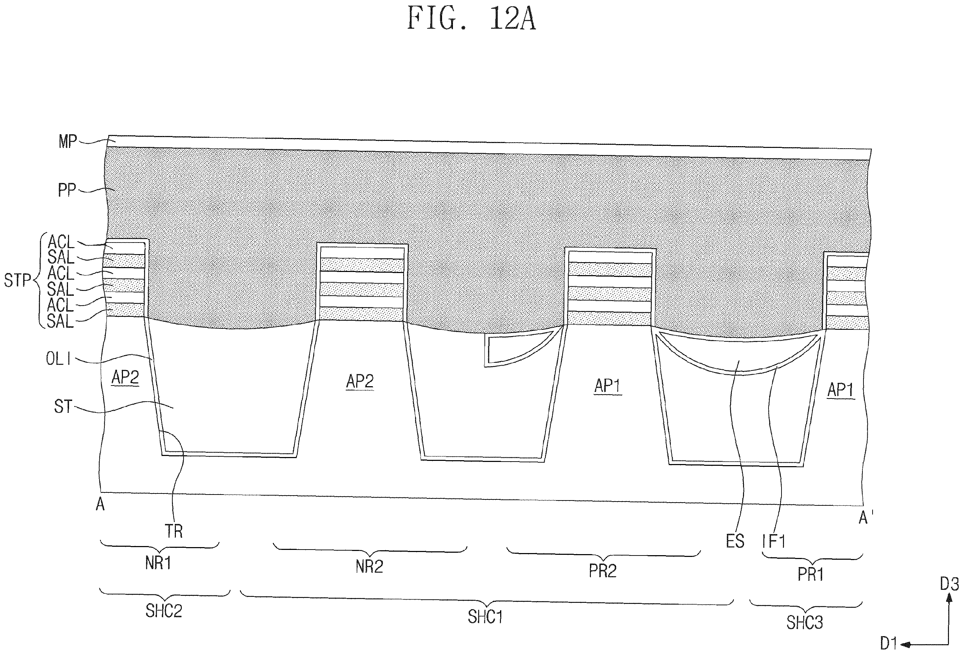

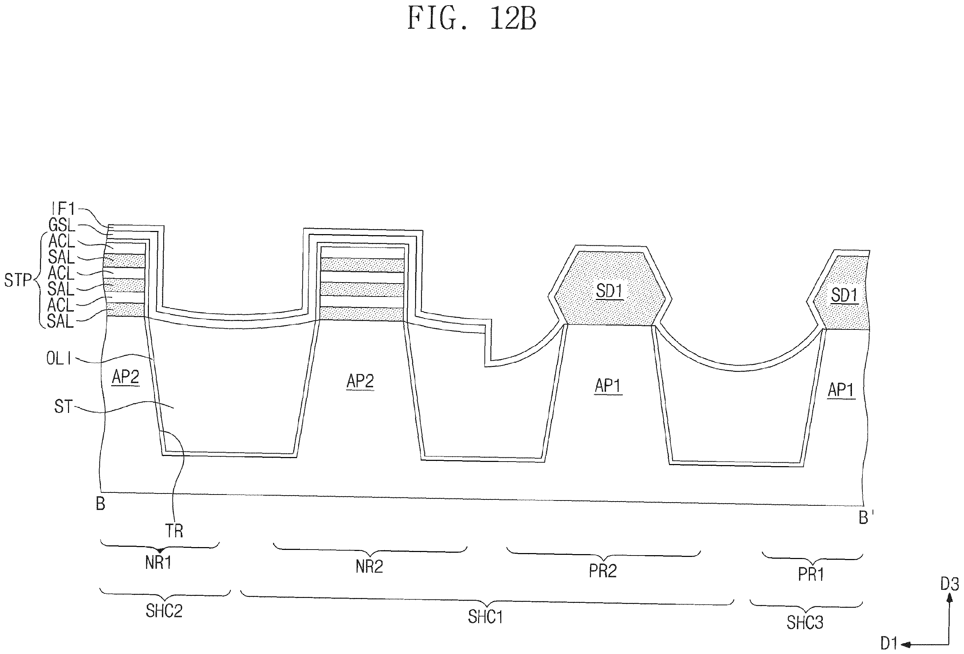

Referring to FIG. 12A and FIG. 12B, first source/drain patterns SD1 may be formed in the first recesses RS1, respectively. For example, a first selective epitaxial growth (SEG) process may be performed using an inner surface of the first recess RS1 as a seed layer to form the first source/drain pattern SD1. The first SEG process may include a chemical vapor deposition (CVD) process or a molecular beam epitaxy (MBE) process.

The first source/drain patterns SD1 may include a semiconductor element (e.g., SiGe) having a lattice constant greater than a lattice constant of a semiconductor element of the substrate 100. Dopants may be injected in-situ during the first SEG process. Alternatively, after the formation of the first source/drain pattern SD1, dopants may be injected or implanted into the first source/drain pattern SD1. The first source/drain pattern SD1 may be doped with the dopants to have a first conductivity type (e.g., a p-type).

A first insulating layer IF1 may be deposited on a surface of the substrate 100. The first insulating layer IF1 may be deposited on an entire top surface of the substrate 100. The first insulating layer IF1 may cover the top surface of the device isolation layer ST on the first PMOSFET region PR1 and the second PMOSFET region PR2. The first insulating layer IF1 may cover the gate spacer layer GSL of the first NMOSFET region NR1 and the second NMOSFET region NR2. In addition, the first insulating layer IF1 may cover a top surface and a sidewall of the first source/drain pattern SD1. The first insulating layer IF1 may cover a top surface, a bottom surface and a sidewall of the empty space ES (see, for example, FIG. 12A). The first insulating layer IF1 may include an insulating material. For example, the first insulating layer IF1 may include at least one of SiOCN, SiCN, or SiN.

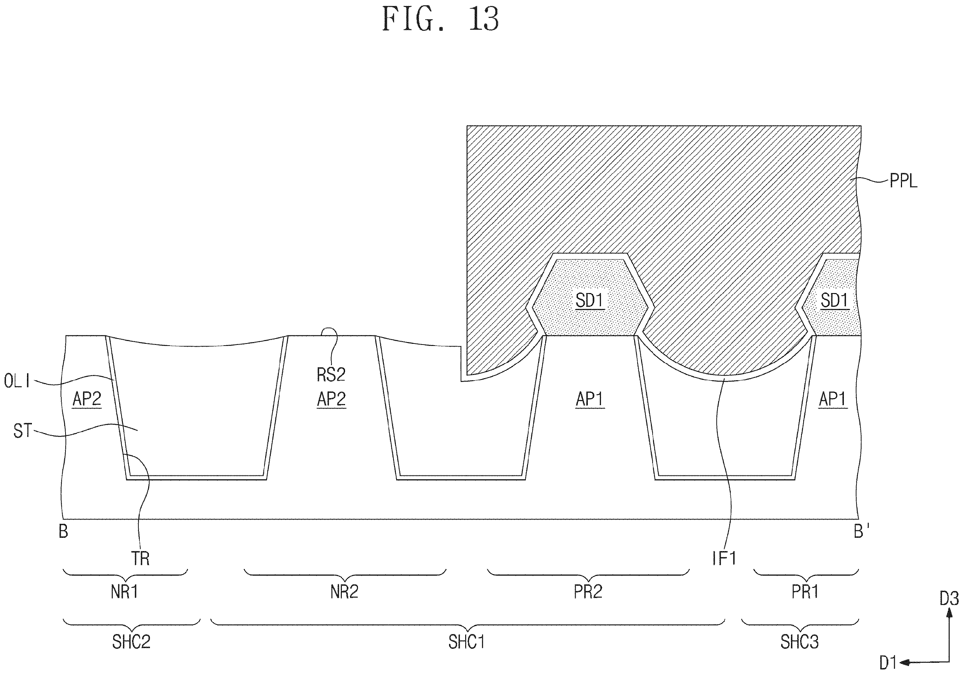

Referring to FIG. 13, a sacrificial layer PPL may be formed on the first PMOSFET region PR1 and the second PMOSFET region PR2. To form the sacrificial layer PPL, a sacrificial layer PPL may be deposited on an entire top surface of the first NMOSFET region NR1 and the second NMOSFET region NR2 and the first PMOSFET region PR1 and the second PMOSFET region PR2. A mask pattern covering the first PMOSFET region PR1 and the second PMOSFET region PR2 may be formed on the deposited sacrificial layer PPL. An etching process may be performed using the mask pattern as an etch mask. The etching process may be performed using the mask pattern to remove the sacrificial layer PPL and the first insulating layer IF1 on the first NMOSFET region NR1 and the second NMOSFET region NR2. On the other hand, in the etching process, the sacrificial layer PPL on the first PMOSFET region PR1 and the second PMOSFET region PR2 may not be removed and may remain.

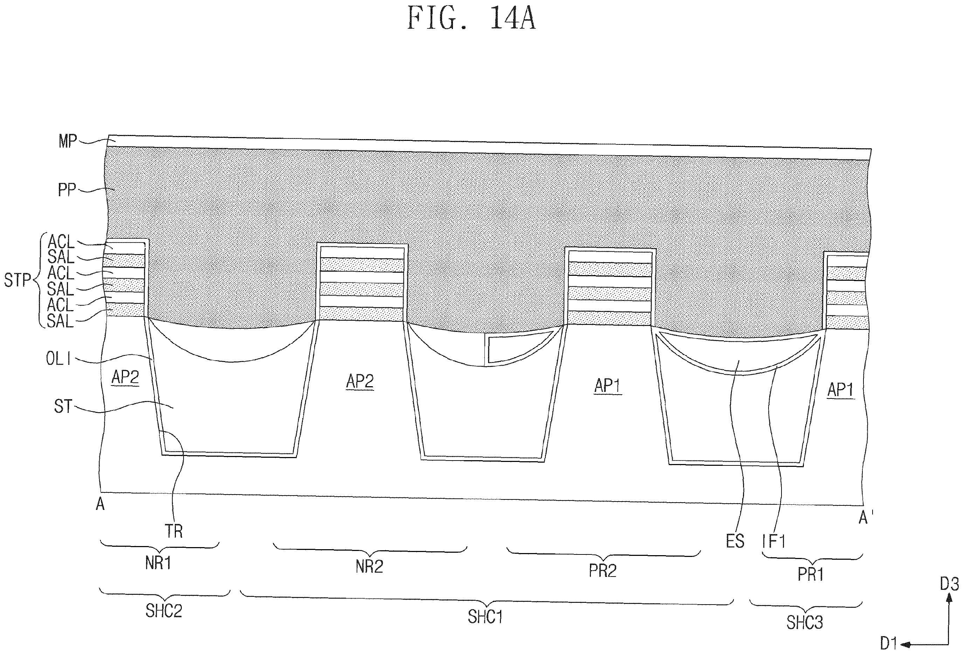

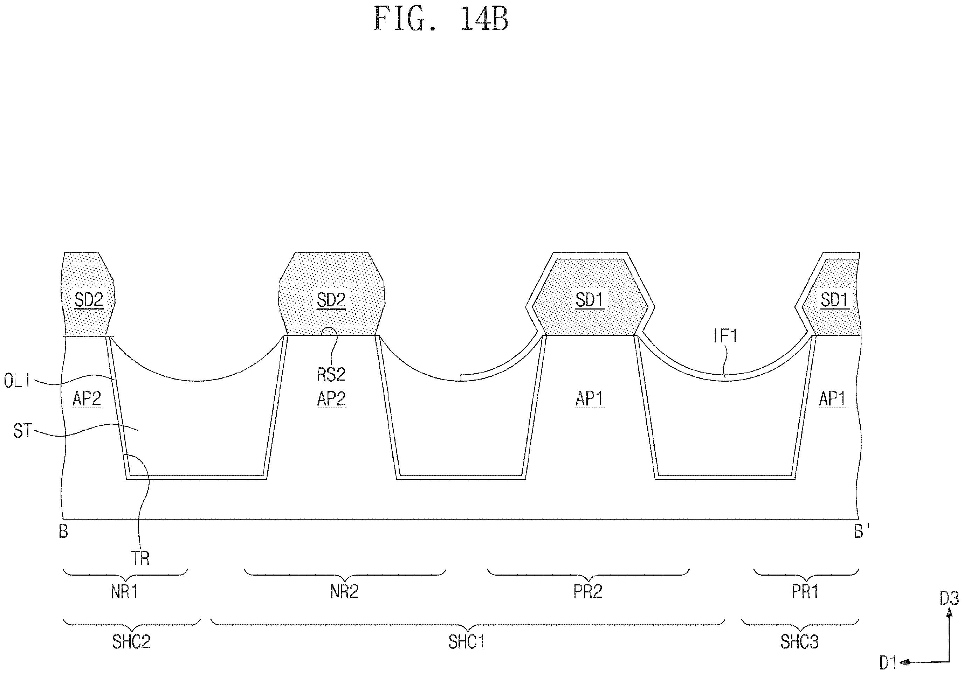

Referring to FIG. 14A and FIG. 14B, the device isolation layer ST on the first NMOSFET region NR1 and the second NMOSFET region NR2 may be etched using the sacrificial layer PPL as an etch mask. In addition, portions of the stack patterns STP on the first NMOSFET region NR1 and the second NMOSFET region NR2 may be removed to form second recesses RS2. A depth of the etched device isolation layer ST may range from about 2nm to 60nm. The etched device isolation layer ST may have a half moon-shaped profile when viewed in a cross-sectional view. The first insulating layer IF1 may remain on the first PMOSFET region PR1 and the second PMOSFET region PR2. That is, the first insulating layer IF1 on the first PMOSFET region PR1 and the second PMOSFET region PR2 may not be removed.

A portion of the device isolation layer ST, which is located on the boundary between the second NMOSFET and PMOSFET regions NR2 and PR2 and that is not etched as shown in FIG. 11A, may be further etched in the first single height cell SHC1. Meanwhile, the etched depth of the device isolation layer ST on the first NMOSFET region NR1 and the second NMOSFET region NR2 may be different from the etched depth of the device isolation layer ST on the first PMOSFET region PR1 and the second PMOSFET region PR2. Thereafter, the sacrificial layer PPL on the first PMOSFET region PR1 and the second PMOSFET region PR2 may be removed.

Referring to FIG. 14A, an empty space ES may be formed between the sacrificial pattern PP and the etched device isolation layer ST. The empty space ES may include an uppermost portion and a lowermost portion. A distance between the uppermost portion and the lowermost portion of the empty space ES may be equal to or less than the depth of the etched device isolation layer ST. The distance between the uppermost portion and the lowermost portion of the empty space ES may range from about 2nm to 60nm. In the first single height cell SHC1, the device isolation layer ST located on the boundary between the second NMOSFET and PMOSFET regions NR2 and PR2 may include a plurality of empty spaces ES. This may be because the first insulating layer IF1 surrounds the empty space ES of the first and second PMOSFET regions PR1 and PR2 in the aforementioned manufacturing process.

Referring to FIG. 14B, second source/drain patterns SD2 may be formed in the second recesses RS2, respectively. For example, the second source/drain pattern SD2 may be formed by performing a second SEG process using an inner surface of the second recess RS2 as a seed layer. For example, the second source/drain pattern SD2 may include the same semiconductor element (e.g., Si) as the substrate 100. The second source/drain patterns SD2 may be doped with dopants to have a second conductivity type (e.g., an n-type). Inner spacers ISP may be formed between the second source/drain pattern SD2 and the sacrificial layers SAL, respectively.

Referring to FIG. 14C, an etched portion RST of the device isolation layer ST may have a round profile when viewed in a cross-sectional view. Adjacent etched portions RST of the device isolation layer ST may be in contact with each other. More particularly, the etched portions RST of the device isolation layer ST, which are adjacent to each other at a first sidewall ISW, may be in contact with each other.

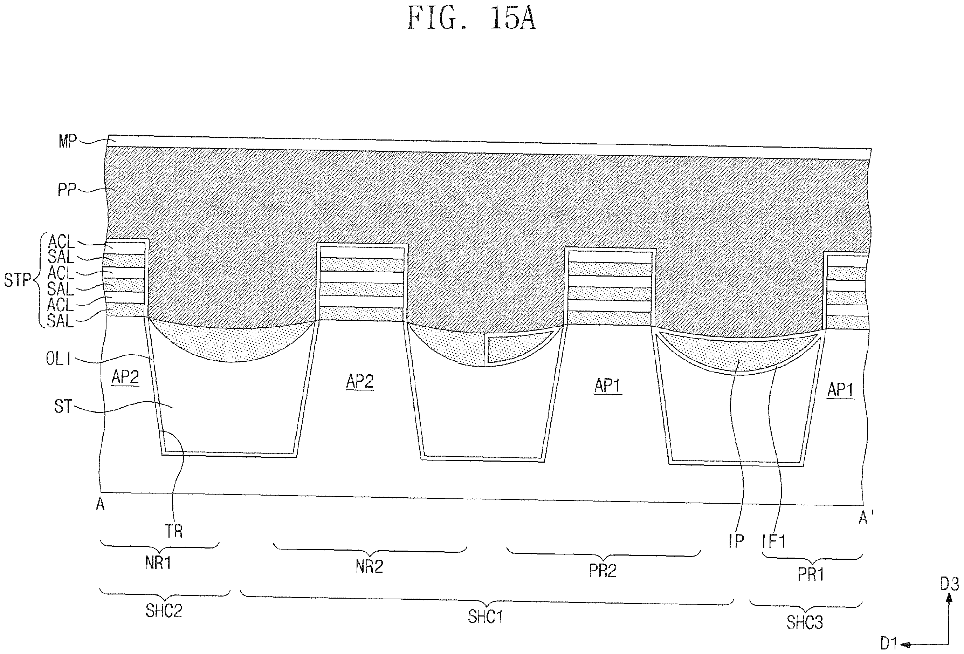

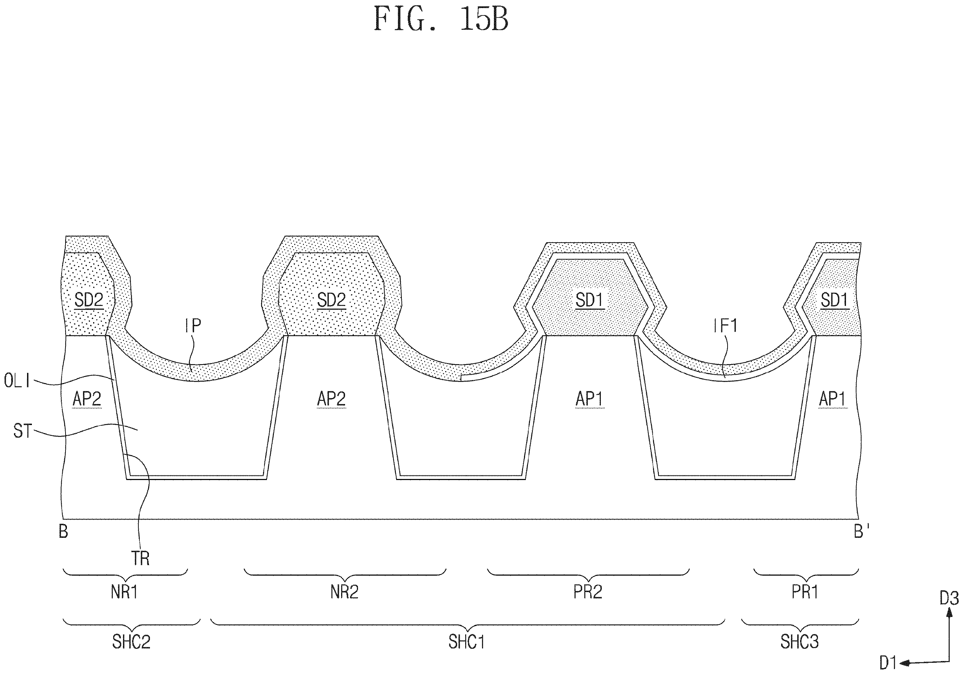

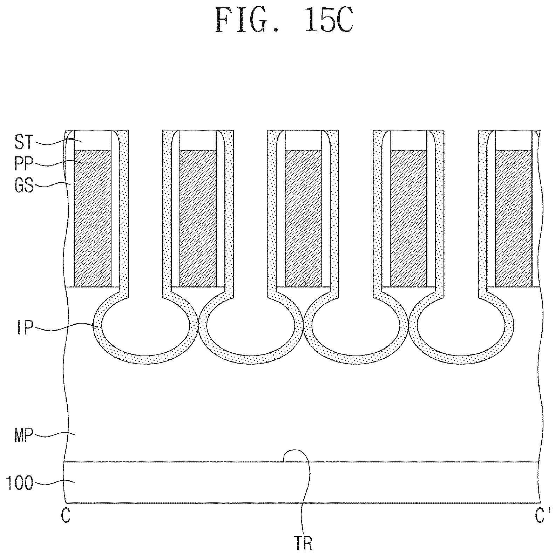

Referring to FIG. 15A, FIG. 15B, and FIG. 15C, the empty space ES of FIG. 14A may be filled with an insulating pattern IP. In the case in which the empty space ES of FIG. 14A is provided, a plurality of insulating patterns IP1 and IP2 may be formed on a single device isolation layer ST (see, for example, FIG. 8E). The insulating pattern IP may be disposed between a concave top surface of the device isolation layer ST and the sacrificial pattern PP. Even though not shown in the drawings, a void VS may be formed in the insulating pattern IP in the process of forming the insulating pattern IP. In some cases, a plurality of voids VS may be formed.

A top surface of the insulating pattern IP may include a portion being in direct contact with the sacrificial pattern PP. In certain embodiments of the inventive concepts, the insulating pattern IP may be spaced apart from the sacrificial pattern PP by the first insulating layer IF1 (see, for example, FIG. 8A). The insulating pattern IP may include an insulating material. More particularly, the insulating pattern IP may include at least one of silicon nitride (SiN), silicon carbon nitride (SiCN), silicon oxycarbide (SiOC), or silicon oxycarbonitride (SiOCN).

Since the empty space ES of FIG. 14A is filled with the insulating pattern IP, when the sacrificial pattern PP is removed and then a gate electrode GE is formed, it is possible to prevent the gate electrode GE from being formed deeply toward the device isolation layer ST. In other words, a depth of the gate electrode GE may be adjusted to prevent the gate electrode GE from being in contact with the first active pattern AP1 or the second active pattern AP2.

Referring to FIG. 15B, the insulating pattern IP may cover a top surface and a sidewall of each of the first source/drain pattern SD1 and the second source/drain pattern SD2. In addition, the insulating pattern IP may cover the top surface of the device isolation layer ST. A thickness of the insulating pattern IP may be greater than a thickness of the first insulating layer IF1. Referring to FIG. 15C, the insulating pattern IP may be conformally formed on the device isolation layer ST and the gate spacer GS. The thickness of the insulating pattern IP may range from about 5nm to 50nm, but embodiments of the inventive concepts are not limited thereto.

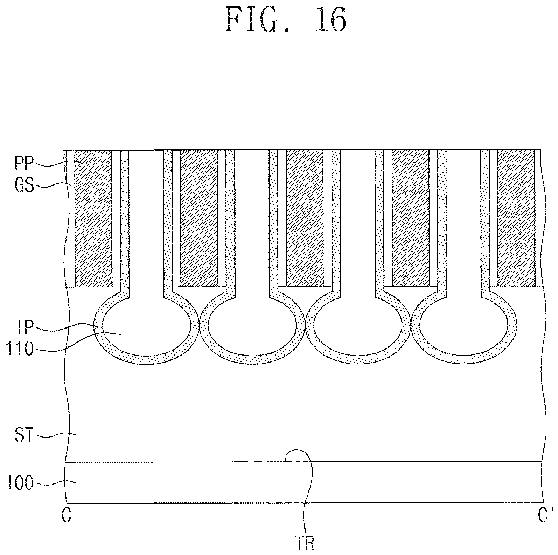

Referring to FIG. 16, FIG. 5A, FIG. 5B, FIG. 5C, FIG. 5D, and FIG. 5E, a first interlayer insulating layer 110 may be formed on the insulating pattern IP. For example, the first interlayer insulating layer 110 may include a silicon oxide layer. The first interlayer insulating layer 110 may be planarized to expose top surfaces of the sacrificial patterns PP. The planarization of the first interlayer insulating layer 110 may be performed using an etchback process or a chemical mechanical polishing (CMP) process. The mask patterns MP may be completely removed in the planarization process. As a result, a top surface of the first interlayer insulating layer 110 may be substantially coplanar with the top surfaces of the sacrificial patterns PP and top surfaces of the gate spacers GS.

The sacrificial patterns PP may be replaced with gate electrodes GE, respectively. In more detail, the exposed sacrificial pattern PP may be selectively removed. The sacrificial layers SAL may be exposed by the removal of the sacrificial pattern PP. The exposed sacrificial layers SAL may be selectively removed. A gate insulating layer GI and the gate electrode GE may be sequentially formed in an empty region formed by the removal of the sacrificial pattern PP and the sacrificial layers SAL. The gate insulating layer GI may surround each of first semiconductor pattern SP1, second semiconductor pattern SP2, and third semiconductor pattern SP3. A gate capping pattern GP may be formed on the gate electrode GE.

A third boundary BD3 extending in the second direction D2 may be defined at the first single height cell SHC1. In the first single height cell SHC1, a fourth boundary BD4 may be defined opposite the third boundary BD3. Gate cutting patterns CT may be formed on the third boundary BD3 and the fourth boundary BD4. The gate cutting patterns CT may overlap with the gate electrodes GE when viewed in a plan view.

Referring again to FIG. 5A, the gate cutting pattern CT may penetrate the gate electrode GE. The gate cutting pattern CT may extend from the insulating pattern IP to the gate capping pattern GP in the third direction D3. The gate cutting pattern CT may include an insulating material such as silicon nitride, silicon oxide, or a combination thereof. The gate electrode GE of a single height cell may be separated from the gate electrode of another single height cell adjacent thereto by the gate cutting pattern CT.

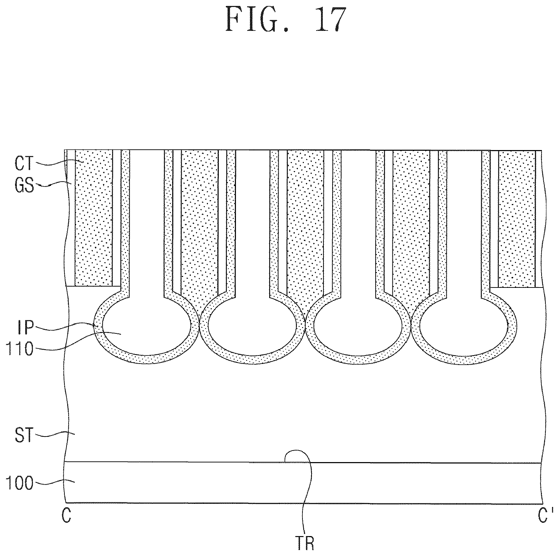

Referring to FIG. 17 and FIG. 7, the insulating pattern IP may include a first portion IPa1 disposed between the first interlayer insulating layer 110 and the gate spacer GS, and a second portion IPa2 disposed between the first interlayer insulating layer 110 and the device isolation layer ST. The second portion IPa2 may have a round profile when viewed in a cross-sectional view. The second portion IPa2 may be in contact with the gate cutting pattern CT.

The insulating pattern IP may include first insulating pattern IPa and the second insulating pattern IPb adjacent to each other. Here, the second portion IPa2 of the first insulating pattern IPa may have a first sidewall ISW. The first sidewall ISW may be in contact with the second portion IPb2 of the second insulating pattern IPb. A cross-sectional view taken along the first sidewall ISW may be the same as FIG. 5A, and as shown in FIG. 5A, the gate cutting pattern CT may be in contact with the insulating pattern IP.

A second interlayer insulating layer 120 may be formed on the first interlayer insulating layer 110. The second interlayer insulating layer 120 may include a silicon oxide layer. Active contacts AC may be formed to penetrate the second interlayer insulating layer 120 and the first interlayer insulating layer 110. The active contacts AC may be electrically connected to the first source/drain patterns SD1 and the second source/drain patterns SD2. A gate contact GC may be formed to penetrate the second interlayer insulating layer 120 and the gate capping pattern GP, and the gate contact GC may be electrically connected to the gate electrode GE.

The formation of each of the active contact AC and the gate contact GC may include forming a barrier pattern BM, and forming a conductive pattern FM on the barrier pattern BM. The barrier pattern BM may be conformally formed and may include a metal layer/a metal nitride layer. The conductive pattern FM may include a low-resistance metal.

Isolation structures DB may be formed at a first boundary BD1 and a second boundary BD2 of the first single height cell SHC1, respectively. The isolation structure DB may penetrate the second interlayer insulating layer 120. The isolation structure DB may penetrate the gate electrode GE. The isolation structure DB may extend into the first active pattern AP1 or the second active pattern AP2. The isolation structure DB may include an insulating material such as silicon oxide or silicon nitride.

A third interlayer insulating layer 130 may be formed on the active contacts AC and the gate contacts GC. A first metal layer M1 may be formed in the third interlayer insulating layer 130. A fourth interlayer insulating layer 140 may be formed on the third interlayer insulating layer 130. A second metal layer M2 may be formed in the fourth interlayer insulating layer 140.

The semiconductor device according to the inventive concepts may include the insulating pattern between the gate cutting pattern and the concave top surface of the device isolation layer. The depths of the gate cutting pattern and the gate electrode may be adjusted when the insulating pattern is formed. Therefore, it may be possible to prevent the gate electrode and the gate cutting pattern from being in contact with the active pattern. This, the capacitor/gate leakage current may be reduced. As a result, the inventive concepts may improve the electrical characteristics and reliability of the semiconductor device.

While embodiments of the inventive concepts have been particularly shown and described, it will be understood by one of ordinary skill in the art that variations in form and detail may be made therein without departing from the spirit and scope of the attached claims.

## Claims

1. A semiconductor device comprising:
a substrate including a first active region and a second active region;
a first active pattern on the first active region;
a second active pattern on the second active region;
a device isolation layer filling a trench between the first active pattern and the second active pattern, the device isolation layer having a concave top surface;
a first gate electrode in the first active region;
a second gate electrode in the second active region;
a gate cutting pattern between the first gate electrode and the second gate electrode and separating the first gate electrode and the second gate electrode; and
an insulating pattern between the gate cutting pattern and the concave top surface of the device isolation layer.

2. The semiconductor device of claim 1, wherein the insulating pattern is disposed between the first gate electrode and the device isolation layer and between the second gate electrode and the device isolation layer.

3. The semiconductor device of claim 1, wherein a top surface of the insulating pattern includes a portion in contact with the gate cutting pattern.

4. The semiconductor device of claim 1, further comprising an insulating layer disposed on a top surface of the insulating pattern.

5. The semiconductor device of claim 1, wherein the insulating pattern has an uppermost portion and a lowermost portion, and
wherein a distance between the uppermost portion and the lowermost portion ranges from about 5nm to 50nm.

6. The semiconductor device of claim 1, wherein the insulating pattern includes at least one of silicon nitride (SiN), silicon carbon nitride (SiCN), silicon oxycarbide (SiOC), or silicon oxycarbonitride.

7. The semiconductor device of claim 1, wherein a top surface of the insulating pattern is a curved surface.

8. The semiconductor device of claim 1, wherein a bottom surface of the insulating pattern is disposed on the concave top surface of the device isolation layer.

9. The semiconductor device of claim 1, wherein the insulating pattern includes a first insulating portion and a second insulating portion, and
wherein the first insulating portion is spaced apart from the second insulating portion by an insulating layer.

10. The semiconductor device of claim 1, wherein the first active pattern comprises a pair of first source/drain patterns and a first channel pattern between the pair of first source/drain patterns, the second active pattern comprises a pair of second source/drain patterns and a second channel pattern between the pair of second source/drain patterns, and the insulating pattern extends to cover the first source/drain patterns and the second source/drain patterns.

11. A semiconductor device comprising:
a substrate;
a device isolation layer on the substrate;
a gate cutting pattern on the device isolation layer;
a gate spacer on a sidewall of the gate cutting pattern;
an interlayer insulating layer on the device isolation layer and the gate spacer; and
an insulating pattern between the device isolation layer and the interlayer insulating layer and between the gate spacer and the interlayer insulating layer,
wherein the insulating pattern includes:
a first portion disposed between the interlayer insulating layer and the gate spacer; and
a second portion disposed between the interlayer insulating layer and the device isolation layer.

12. The semiconductor device of claim 11, wherein the insulating pattern includes a first insulating pattern adjacent to a second insulating pattern,
wherein the second portion of the first insulating pattern is in contact with the second portion of the second insulating pattern.

13. The semiconductor device of claim 11, wherein the second portion has a round profile in a cross-sectional view.

14. The semiconductor device of claim 11, wherein the gate cutting pattern is on and in contact with the second portion of the insulating pattern.

15. The semiconductor device of claim 11, wherein the insulating pattern includes at least one of silicon nitride (SiN), silicon carbon nitride (SiCN), silicon oxycarbide (SiOC), or silicon oxycarbonitride.
